# EUROPÄISCHE PATENTSCHRIFT

(11) **EP 3 047 336 B1**
(45) Veröffentlichungstag und Bekanntmachung des Hinweises auf die Patenterteilung: **10.01.2018**
(21) Anmeldenummer: 14766731.5
(22) Anmeldetag: 18.09.2014
(51) Int. Cl.: G03F 7/20, G03F 7/09, G03F 7/30

(54) **DIGITAL BEBILDERBARES FLEXODRUCKELEMENT UND VERFAHREN ZUR HERSTELLUNG VON FLEXODRUCKPLATTEN**
DIGITALLY EXPOSABLE FLEXOGRAPHIC PRINTING ELEMENT AND METHOD FOR PRODUCING FLEXOGRAPHIC PRINTING PLATES
ÉLÉMENT FLEXOGRAPHIQUE POUR IMAGERIE DIGITALE ET PROCÉDÉ DE FABRICATION DE CET ELEMENT

(30) Priorität: 18.09.2013 EP 13185009
(43) Veröffentlichungstag der Anmeldung: 27.07.2016
(73) Patentinhaber: Flint Group Germany GmbH, 70469 Stuttgart (DE)
(72) Erfinder: STEBANI, Uwe, 67592 Flörsheim-Dalsheim (DE); BECKER, Armin, 67259 Grossniedesheim (DE); BEYER, Matthias, 76327 Pfinztal (DE); RIEWE, Denis, 77731 Willstätt (DE); REIFSCHNEIDER, Andreas, 68159 Mannheim (DE)
(74) Vertreter: Schuck, Alexander
(86) Internationale Anmeldenummer: PCT/EP2014/069853
(87) Internationale Veröffentlichungsnummer: WO 2015/040094

(56) Entgegenhaltungen:
- EP-A2- 1 156 368
- WO-A1-2011/041046
- WO-A1-2015/007667
- DE-A1- 2 820 815
- DE-A1-102007 063 169
- DE-A1-102007 063 202
- DE-A1-102009 032 217
- US-A- 4 722 355
- US-A- 5 262 275
- US-A1- 2004 081 908
- US-A1- 2012 214 102
- US-A1- 2012 270 156

## Beschreibung

Die vorliegende Erfindung betrifft ein Verfahren zur Herstellung von digital bebilderbare Flexodruckelementen zur Herstellung von Flexodruckformen, welche eine organisch lösliche, reliefbildende Schicht, eine wasserlösliche Barriereschicht für Sauerstoff sowie eine wasserlösliche, laserablatierbare Maskenschicht umfassen. Das Verfahren zur Herstellung von Flexodruckformen umfasst ein zweistufiges Auswaschverfahren unter Verwendung wässriger und organischer Auswaschmittel. Digital bebilderbare Flexodruckelemente sind prinzipiell bekannt. Sie umfassen mindestens einen dimensionsstabilen Träger, eine fotopolymerisierbare Schicht sowie eine digital bebilderbare Schicht. Bei der digital bebilderbaren Schicht kann es sich beispielsweise um eine laserablatierbare Schicht, um eine mittels Ink-Jet-Drucker beschreibbare Schicht oder um eine thermographische Schicht handeln, wobei laserablatierbare Schichten am gebräuchlichsten sind.

Laserablatierbare Schichten, auch LAMS (Iaserablatierbare Maskenschichten) genannt, sind für die Wellenlänge des aktinischen Lichtes opak und umfassen üblicherweise ein Bindemittel sowie mindestens einen IR-Absorber wie beispielsweise Ruß. Ruß bewirkt auch, dass die Schicht opak ist. In die laserablatierbare Schicht kann mittels eines IR-Lasers eine Maske eingeschrieben werden, d.h. die Schicht wird an den Stellen, an denen sie vom Laserstrahl getroffen wird, zersetzt und die darunter angeordnete fotopolymerisierbare Schicht wird freigelegt. Die laserablatierbare Maskenschicht kann unmittelbar auf die fotopolymerisierbare Schicht aufgebracht werden oder zwischen der fotopolymerisierbaren Schicht und der laserablatierbaren Maskenschicht können sich noch weitere Schichten befinden, beispielsweise eine Sperrschicht. Beispiele für die Bebilderung von Flexodruckelementen mit IR-ablativen Masken sind beispielsweise in US 5,262,275 oder EP-A 1 069 475 offenbart. Verfahren zur Herstellung von Flexodruckformen sind beispielsweise in EP-A-1 156 368 A2 oder in US 2004/081905 A1 offenbart.

Die Herstellung von Flexodruckformen ausgehend von fotopolymerisierbaren, digital bebilderbaren Flexodruckelementen erfolgt wie folgt: Nach dem Einschreiben einer Maske in die digital bebilderbare Schicht wird das Flexodruckelement durch die Maske hindurch mit UV-Strahlung bzw. UV/VIS-Strahlung belichtet. Die fotopolymerisierbare Schicht polymerisiert in den von der Maske nicht mehr abgedeckten Bereichen, während in den abgedeckten Bereichen keine Polymerisation erfolgt. Nach der Belichtung werden die Reste der Maske sowie die nicht polymerisierten Anteile der fotopolymerisierbaren Schicht entfernt. Dies kann unter Verwendung von einem oder mehreren Lösemitteln oder auch thermisch erfolgen. Bei Verwendung von Lösemitteln schließt sich ein Trockenschritt an, und üblicherweise wird die erhaltene Flexodruckform noch nachbehandelt, beispielsweise durch Belichten mit UVA- und/oder UVC-Licht.

Bei digital bebilderbaren Flexodruckelementen erfolgt die Hauptbelichtung mittels UV- bzw. UV/VIS-Strahlung, üblicherweise in Gegenwart von Luftsauerstoff.

Es ist bekannt, dass bei der Hauptbelichtung die Anwesenheit von Sauerstoff einen ganz erheblichen Einfluss auf die Form der druckenden Reliefelemente hat, ganz besonders auf die Form feiner Rasterelemente. Molekularer Sauerstoff ist bekanntlich ein Diradikal und kann daher mit anderen Radikalen reagieren. Die Anwesenheit von molekularem Sauerstoff während der durch UV-Licht ausgelösten radikalischen Polymerisation führt dazu, dass der Sauerstoff die Radikalkettenreaktion an der Oberfläche der fotopolymerisierbaren Schicht unterbricht und somit, dass die Oberfläche der Reliefelemente nicht mehr ausreichend polymerisiert. Weiter unterhalb der Oberfläche gelegene Bereiche der fotopolymerisierbaren Schicht werden weniger beeinflusst. Im Zuge der Entwicklung der Schicht nach der Polymerisation werden die nicht ausreichend polymerisierten Schichten ebenfalls entfernt. Die Reliefelemente sind somit kleiner als sie eigentlich sein sollten und weisen abgerundete Ecken auf. Dieser Effekt ist beispielsweise anschaulich in EP 2 128 702 A1, Seite 15, Figur 1 dargestellt.

Grundsätzlich sollte der störende Einfluss von Sauerstoff bei der Belichtung von Flexodruckelementen ausgeschaltet werden, damit die vorgesehenen Reliefelemente bis zur Oberfläche vollständig polymerisiert werden, und somit feinere Details auf der Platte abgebildet werden können und in Vollflächen sehr feine Strukturen abgebildet werden können. Dies dient vor allem zur Verbesserung der Farbübertragung und des Farbliegeverhaltens.

Es ist daher vorgeschlagen worden, die fotopolymerisierbare Schicht während der Hauptbelichtung vor Sauerstoff zu schützen.

Es ist prinzipiell möglich, unter Schutzgas oder unter Verwendung eines Vakuumrahmens zu belichten, aber diese Vorgehensweise ist mit zusätzlichem apparativem Aufwand verbunden und wird daher üblicherweise vermieden.

Weiterhin ist vorgeschlagen worden, die fotopolymerisierbare Schicht in Flexodruckelementen durch zusätzliche Barriereschichten vor Luftsauerstoff zu schützen. Solche Barriereschichten sollen die Diffusion von Sauerstoff in die fotopolymerisierbare Schicht verhindern oder zumindest minimieren.

US 5,262,275 offenbart Flexodruckelemente zur Herstellung von Flexodruckformen, welche einen Träger, eine fotopolymerisierbare Schicht, eine darauf aufgebrachte Barriereschicht und eine darauf aufgebrachte laserablatierbare Maskenschicht umfassen. Die Barriereschicht soll einerseits die Migration von Komponenten, beispielsweise von Monomeren aus der fotopolymerisierbaren Schicht in die laserablatierbare Schicht verhindern und andererseits die fotopolymerisierbare Schicht vor atmosphärischem Sauerstoff während der Belichtung des Flexodruckelements schützen. Es werden fotopolymerisierbare als auch nicht fotopolymerisierbare Barriereschichten vorgeschlagen. Als Materialien für nicht fotopolymerisierbare Barriereschichten werden sowohl wasserlösliche als auch in organischen Bindemitteln lösliche Bindemittel vorgeschlagen, nämlich Polyamide, Polyvinylalkohol, Hydroxyalkylcellulose, Ethylen-Vinylacetat-Copolymere, amphotere Interpolymere und Kombinationen davon. Die Dicke der Barriereschicht beträgt 0,25 µm bis 76 µm, bevorzugt 0,38 bis 64 µm.

WO 2012/145111 A1 offenbart fotopolymerisierbare Flexodruckelemente zur Herstellung von Flexodruckformen, welche einen Träger, eine fotopolymerisierbare Schicht, eine darauf aufgebrachte Barriereschicht und eine darauf aufgebrachte laserablatierbare Schicht umfassen. Die Barriereschicht weist einen Diffusionskoeffizienten für O₂ von weniger als 6,9*10⁻⁹ m²/s und eine optische Transparenz von mindestens 50 %, bevorzugt mindestens 75 % auf. Die Schichtdicke der Barriereschicht beträgt 1 bis 100 µm, bevorzugt 1 bis 20 µm. Als Materialien für die Barriereschicht werden sowohl wasserlösliche als auch in organischen Bindemitteln lösliche Bindemittel vorgeschlagen, nämlich Polyamide, Polyvinylalkohol, Hydroxyalkylcellulose, Polyvinylpyrrolidon, Ethylen-Vinylacetat-Copolymere, amphotere Interpolymere, Celluloseacetatbutyrat, Alkylcellullose, Butyral, cyclische Kautschuke oder Kombinationen davon.

US 2012/0164584 A1 offenbart ein Verfahren zur Herstellung von Flexodruckplatten unter Verwendung eines digital bebilderbaren Flexodruckelements, welches eine laserablatierbare Schicht aufweist. Nach dem Einschreiben einer Maske in die laserablatierbare Schicht wird eine Barriereschicht auf die Oberseite des Flexodruckelements aufgebracht, d.h. sie bedeckt sowohl die freigelegten Stellen der fotopolymerisierbaren Schicht sowie die noch vorhandenen Bereiche der laserablatierbare Schicht selbst. Anschließend wird mit UV-Licht belichtet. Als Materialien für die Barriereschicht werden sowohl wasserlösliche als auch in organischen Lösungsmitteln lösliche Bindemittel vorgeschlagen, nämlich Polyamide, Polyvinylalkohol, Hydroxyalkylcellulose, Polyvinylpyrrolidon, Ethylen-Vinylacetat-Copolymere, amphotere Interpolymere, Celluloseacetatbutyrat, Alkylcellullose, Butyral, cyclische Kautschuke oder Kombinationen davon. Weiterhin kann es sich um Öle handeln. Die Dicke der Barriereschicht beträgt 1 bis 100 µm, bevorzugt 1 bis 20 µm. Das Aufbringen der Barriereschicht bedeutet einen zusätzlichen Verfahrensschritt zwischen Bebildern und Belichten und somit zusätzlichen Aufwand.

US 8,492,074 B2 offenbart ein Verfahren zur Herstellung von Flexodruckplatten, unter Verwendung eines digital bebilderbaren Flexodruckelements, welches eine laserablatierbare Schicht aufweist. Auch hier wird nach dem Einschreiben einer Maske in die laserablatierbare Schicht eine Barriereschicht auf die Oberseite des Flexodruckelements aufgebracht, d.h. sie bedeckt sowohl die freigelegten Stellen der fotopolymerisierbaren Schicht sowie die noch vorhandenen Bereiche der laserablatierbaren Schicht selbst. Anschließend wird mit UV-Licht belichtet. Die Barriereschicht umfasst mindestens zwei verschiedene Harze, wobei die Harze bevorzugt aus der Gruppe von Polyvinylpyrrolidon, Shellack, Polyvinylbutyral, Polyvinylidenchlorid oder Vinylchloridcopolymeren ausgewählt werden. Die Barriereschicht weist bevorzugt einen Diffusionskoeffizienten für O₂ von weniger als 6,9*10⁻⁹ m²/s auf. US 8,492,074 B2 offenbart weiterhin, dass eine derartige Barriereschicht auch zwischen der fotopolymerisierbaren Schicht und der laserablatierbaren Maskenschicht aufgebracht sein kann.

EP 2 284 612 A1 offenbart digital bebilderbare Flexodruckelemente umfassend einen Träger, eine wasserentwickelbare fotopolymerisierbare Schicht, eine Sauerstoff-Sperrschicht einer Dicke von 0,2 µm bis 2µm, sowie einer wärmeempfindlichen, mittels eines Lasers beschreibbaren Maskenschicht einer Dicke von 0,5 µm bis 5 µm. Nach dem Einschreiben einer Maske in die wärmeempfindliche Schicht und bildmäßigem Belichten wird das belichtete Flexodruckelement in einem einstufigen Prozess unter Verwendung von wässrigen Auswaschmitteln entwickelt. Die Sauerstoff-Sperrschicht kann wasserlöslich sein oder auch nicht. Nicht wasserlösliche Schichten werden mechanisch durch die Bürsten des Auswaschgerätes entfernt. Auch das Bindemittel in der wärmeempfindlichen Schicht kann sowohl wasserlöslich oder auch nicht wasserlöslich sein.

WO 2005/101130 A1 offenbart einen mehrschichtigen Maskenfilm zur Herstellung von Flexodruckformen. Der Maskenfilm umfasst einen Träger, eine IR-empfindliche Schicht, beispielsweise eine IR-ablative Schicht sowie optional weitere Schichten, beispielsweise eine Barriereschicht oder eine Release-Schicht. Der Maskenfilm kann mit einem Laser bebildert werden, wird anschließend auf ein fotopolymerisierbares Flexodruckelement auflaminiert, wobei die Trägerschicht des Maskenfilms die oberste Schicht bildet. Der Verbund aus Maskenschicht wird anschließend vollflächig belichtet, wobei die Belichtung durch die Trägerschicht erfolgen kann oder die Trägerschicht vor dem Belichten abgezogen werden kann. Nach dem Belichten kann die Trägerfolie (sofern nicht schon entfernt) mit oder auch ohne die eigentliche Maskenschicht abgezogen werden, und das belichtete Flexodruckelement kann in üblicher Art und Weise entwickelt werden.

Laminierverfahren wie das nachträgliche Aufbringen einer Sauerstoff sperrenden Folie oder das nachtägliche Aufbringen eines zuvor belichteten Maskenfilms sind nicht zu empfehlen, da bei jeder Laminierung Fehlstellen entstehen können, beispielsweise durch Einschluss von Staubpartikeln oder Einschluss von Luft. Jede kleinste Fehlstelle macht das Flexoklischee aber unbrauchbar. Ferner ist das Laminieren bzw. das nachträgliche Aufbringen von Barriereschichten ein zusätzlicher Arbeitsschritt im Zuge der Verarbeitung des Flexodruckelements und daher beim Anwender äußerst unerwünscht.

Weiterhin sind im Stand der Technik spezielle Belichtungsverfahren bekannt, beispielsweise aus WO 2012/010459 A1 oder WO 2008/135865 A2, bei denen die Belichtung der Flexodruckelemente mittels intensiver UVA-LED Strahlung erfolgt. Durch die hohe Energie der Belichtung und die dementsprechend schnelle Polymerisation wird der Einfluss störenden Sauerstoffs minimiert, und es können auch feine Oberflächenstrukturen auf den Flexodruckklischees abgebildet werden. Die Belichtungsgeräte sind aber erheblich teurer als marktübliche UVA-Röhrenbelichter. Des Weiteren sind zur Abbildung feiner Details relativ lange Belichtungszeiten notwendig, was die Akzeptanz dieser Technik im Markt weiter erschwert.

Übliche, digital bebilderbare Flexodruckelemente mit Barriereschicht gemäß Stand der Technik umfassen in der Regel eine in organischen Auswaschmitteln lösliche fotopolymerisierbare, reliefbildende Schicht. Die belichteten Flexodruckelemente werden in der Regel in einem Schritt mit organischen Lösemittelgemischen ausgewaschen, wobei die Reste der digital bebilderbaren Schicht, die Barriereschicht sowie die nicht polymerisierten Anteile der reliefbildenden Schicht entfernt werden. Die verwendeten Auswaschmittel umfassen in der Regel als Hauptkomponente unpolare Kohlenwasserstoffe als Lösemittel und einen oder mehrere mäßig polare Alkohole als Co-Lösemittel. Der Alkoholzusatz dient dazu, auch etwas polarere Komponenten der Barriereschicht und der laserablatierbaren Schicht zu lösen.

Im laufenden Betrieb kommt es auf Grund der höheren Flüchtigkeit der Alkohole im Vergleich zu derjenigen der Kohlenwasserstoffe zu einer Veränderung der Zusammensetzung des Auswaschmittels, was die Qualität des Auswaschergebnisses beeinträchtigt. Daher muss die Zusammensetzung der Auswaschlösung laufend kontrolliert werden. Ist die Auswaschlösung verbraucht und wird durch Destillation regeneriert, muss die Zusammensetzung neu eingestellt werden. Ferner ist der Geruch der Auswaschlösungen im Regelfalle unangenehm, was überwiegend von dem mäßig polaren Alkohol verursacht wird. Weiterhin kommt es beim Betrieb der Auswaschgeräte zu einer stetigen Verschmutzung durch Ruß der laserablatierbaren Maskenschicht, was eine häufige Gerätereinigung zur Folge hat. Es ist äußerst wünschenswert, ein Auswaschverfahren zur Verfügung zu haben, welches nur mit Kohlenwasserstoffen als Auswaschmitteln auskommt und weniger Wartungsaufwand benötigt.

Aufgabe der Erfindung war es, digital bebilderbare Flexodruckelemente herzustellen, die eine hohe Auflösung, einen hohen Tonwertumfang und die Möglichkeit der Oberflächenstrukturierung bieten, und die einfach und in kurzer Zeit zu einer Flexodruckform verarbeitet werden können.

Überraschenderweise wurde gefunden, dass die genannten Anforderungen erfüllt werden können, wenn bei einem digital bebilderbaren Flexodruckelement eine in organischen Lösemitteln oder Lösemittelgemischen lösliche fotopolymerisierbare Schicht mit einer wasserlöslichen Barriereschicht und einer wasserlöslichen LAMS Schicht kombiniert wird, und das belichtete Flexodruckelement mittels eines zweistufigen Verfahrens ausgewaschen wird.

Dementsprechend wurden digital bebilderbare, fotopolymerisierbare Flexodruckelemente zur Herstellung von Flexodruckformen gefunden welche -in der genannten Reihenfolge übereinander angeordnet- mindestens
(A) einen dimensionsstabilen Träger,
(B) mindestens eine in organischen Lösemitteln lösliche oder dispergierbare, fotopolymerisierbare, reliefbildende Schicht einer Schichtdicke von 300 µm bis 6000 µm, umfassend mindestens ein elastomeres Bindemittel, ein ethylenisch ungesättigtes Monomer sowie einen Fotoinitiator oder ein Fotoinitiatorsystem,
(C) eine für UVA-Licht transparente Barriereschicht für Sauerstoff mit einer Schichtdicke von 0,3 µm bis 5 µm,
(D) eine laserablatierbare Maskenschicht einer Schichtdicke von 0,3 µm bis 5 µm, umfassend mindestens ein elastomeres Bindemittel und UV/VIS-Licht absorbierende Materialien, wobei die Schichtdicke und/oder die Menge der lichtabsorbierenden Materialien so bemessen werden, dass die optische Dichte der Schicht für UVA-Strahlung 2 bis 5 beträgt, sowie
(E) optional eine abziehbare Deckfolie,
   umfassen, wobei sowohl die Barriereschicht (C) als auch die laserablatierbare Maskenschicht (D) wasserlöslich oder wasserdispergierbar sind.
Erfindungsgemäß wurde ein Verfahren zur Herstellung von Flexodruckformen gefunden, bei dem man die genannten Flexodruckelemente einsetzt und welches mindestens die folgenden Verfahrensschritte umfasst:
(0) Abziehen der Deckfolie (E) sofern vorhanden,
(1) Einschreiben einer Maske in die laserablatierbare Maskenschicht (D) mithilfe eines IR-Lasers,
(2) Belichten des bebilderten Flexodruckelements mit UVA-Strahlung durch die gebildete Maske hindurch,
(3) Entfernen der Reste der laserablatierbaren Maskenschicht (D) und der Barriereschicht (C) unter Verwendung eines wässrigen Auswaschmittels, welches mindestens 90 Gew.-% Wasser umfasst,
(4) Entfernen der nicht polymerisierten Anteile der reliefbildenden Schicht (B) unter Verwendung eines organischen Auswaschmittels,
(5) Trocknen der erhaltenen Flexodruckform, sowie
(6) Nachbehandeln mit UVA- und/oder UVC-Licht.

In einer bevorzugten Ausführungsform des Verfahrens handelt es sich um ein flächenförmiges Flexodruckelement und man führt die Verfahrensschritte (3) und (4) unter Verwendung eines Zwei-Zonen-Waschers durch.

Verzeichnis der Abbildungen:
- Abbildung 1: Schematische Darstellung eines Zwei-Zonen-Waschers
- Abbildung 2: Mikroskopaufnahmen des Flexoklischees aus Vergleichsbeispiel 1
- Abbildung 3: Mikroskopaufnahmen des Flexoklischees aus Beispiel 1
- Abbildung 4: Mikroskopaufnahme des Flexoklischees aus Beispiel 2
- Abbildung 5: Mikroskopaufnahmen des Flexoklischees aus Beispiel 4

Zu der Erfindung ist im Einzelnen das Folgende auszuführen:
Im Folgenden werden die Begriffe "Flexodruckplatte", "Flexodruckform" oder "Klischee" für eine bereits vernetzte, druckfertige Druckform verwendet. Der Begriff "Flexodruckelement" wird in üblicher Art und Weise für das fotopolymerisierbare Ausgangsmaterial verwendet, welches zur Herstellung von Flexodruckformen bzw. Flexodruckplatten eingesetzt wird.

Die erfindungsgemäß verwendeten Flexodruckelemente umfassen mindestens die folgenden, übereinander angebrachten Schichten: Einen dimensionsstabilen Träger (A), eine reliefbildende Schicht (B), eine Barriereschicht (C) und eine laserablatierbare Maskenschicht (D). Selbstverständlich können noch weitere Schichten vorhanden sein. Beispiele umfassen eine Deckfolie (E) sowie Haftschichten.

Bei den Flexodruckelementen kann es sich sowohl um zylinderförmige Flexodruckelemente (Sleeves) wie um plattenförmige Flexodruckelemente handeln.

### Dimensionsstabiler Träger (A)

Das Flexodruckelement umfasst in prinzipiell bekannter Art und Weise einen dimensionsstabilen Träger. Die Art des Trägers richtet sich nach der Art des Flexodruckelements.

Handelt es sich bei dem Flexodruckelement um ein flächiges Gebilde zur Herstellung einer Flexodruckplatte, dann handelt es sich bei dem dimensionsstabilen Träger (A) in prinzipiell bekannter Art und Weise um eine dimensionsstabile Trägerfolie, welche üblicherweise eine Dicke von 50 µm bis 300 µm aufweist. Bei dem Material der Trägerfolie kann es sich beispielweise um Stahl oder Aluminium oder um Kunststoffe wie beispielsweise Polyethylenterephalat, Polybutylenterephalat, Polyethylennaphthalat oder Polycarbonat handeln. Geeignet sind insbesondere PET-Folien einer Dicke von 100 bis 200 µm.

Handelt es sich bei den Flexodruckelementen um zylindrische Formen (Sleeves), so kommen als dimensionsstabile Träger neben runden Polyesterhülsen auch mit Glasfasern verstärkte Polyester-Hülsen oder andere runde Trägermaterialien in Frage. Die dimensionsstabilen Träger (A) können optional mit üblichen, haftvermittelnden Schichten behandelt sein.

### Reliefbildende Schicht (B)

Das Flexodruckelement umfasst weiterhin mindestens eine in organischen Lösemitteln lösliche oder dispergierbare, fotopolymerisierbare, reliefbildende Schicht (B) einer Schichtdicke von 300 µm bis 6000 µm, umfassend mindestens ein elastomeres Bindemittel, ein ethylenisch ungesättigtes Monomer sowie einen Fotoinitiator oder ein Fotoinitiatorsystem. Neben den genannten Komponenten können optional noch weitere Komponenten wie beispielsweise Weichmacher vorhanden sein. Bei den elastomeren Bindemitteln kann es sich beispielsweise um thermoplastisch-elastomere Blockcopolymere, beispielsweise Styrol-Butadien-, Styrol-Isopren-Blockcopolymere oder Ethylen-Propylen-Dien-Copolymere handeln. In organischen Lösemitteln lösliche oder zumindest dispergierbare Zusammensetzungen für reliefbildende Schichten sind dem Fachmann prinzipiell bekannt, und er wählt je nach den gewünschten Eigenschaften der Flexodruckplatte eine geeignete Zusammensetzung.

Selbstverständlich kann das Flexodruckelement auch mehrere in organischen Lösemitteln lösliche oder dispergierbare, fotopolymerisierbare, reliefbildende Schichten übereinander umfassen. Flexodruckelemente mit einem mehrschichtigen Aufbau der fotopolymerisierbaren, reliefbildenden Schicht sind dem Fachmann ebenfalls bekannt.

Die Polarität organischer Lösemittel kann in prinzipiell bekannter Art und Weise durch den sogenannten Löslichkeitsparameter beschrieben werden (Löslichkeitsparameter nach Hansen, J. Appl. Polym. Sci, 5 (15), 339 (1961)). In einer bevorzugten Ausführungsform der Erfindung handelt es sich bei der reliefbildenden Schicht (B) um eine in organischen Lösemitteln bzw. Lösemittelgemischen mit einem Löslichkeitsparameter < 11 (cal/cm³)^{1/2} lösliche Schicht.

In einer besonders bevorzugten Ausführungsform handelt es sich bei der reliefbildenden Schicht (B) um eine in reinen Kohlenwasserstoffen oder Kohlenwasserstoffgemischen lösliche Schicht.

Die mindestens eine reliefbildende Schicht (B) kann unmittelbar auf dem dimensionsstabilen Träger (A) aufgebracht sein. Zwischen der reliefbildenden Schicht (B) und dem dimensionsstabilen Träger (A) können optional noch weitere Schichten angeordnet sein. Beispiele umfassen Haft- bzw. Klebeschichten sowie kompressible und elastische Unterschichten.

### Wasserlösliche Barriereschicht für Sauerstoff (C)

Auf die fotopolymerisierbare, reliefbildende Schicht (B) ist eine wasserlösliche oder wasserdispergierbare, für UVA-Licht transparente Barriereschicht für Sauerstoff aufgebracht.

Der Begriff "für UVA-Licht transparent" schließt selbstverständlich nicht aus, dass gewisse Anteile von UVA-Licht absorbiert werden könnten. Es muss aber gewährleistet sein, dass im Zuge der UVA-Belichtung des Flexodruckelements noch die Polymerisation der reliefbildenden Schicht (B) möglich ist.

Die Barriereschicht (C) hat die Aufgabe, die Nachdiffusion von Sauerstoff in die reliefbildende Schicht (B) während der vollflächigen Belichtung des Flexodruckelements zu verhindern. Bevorzugt sollte die Sauerstoffdurchlässigkeit der Barriereschicht kleiner als 100, bevorzugt kleiner als 20 (cm³ x 100 µm)/(m²x d x bar) sein.

Die Barriereschicht (C) umfasst mindestens ein wasserlösliches oder wasserdispergierbares Bindemittel. Selbstverständlich können auch Gemische mehrerer verschiedener Bindemittel verwendet werden. Es kann prinzipiell jedes wasserlösliche Bindemittel eingesetzt werden, mit welchem sich eine geringe Sauerstoffdurchlässigkeit erreichen lässt, insbesondere die oben angegebene Sauerstoffdurchlässigkeit unterschreiten lässt. Das Bindemittel der Barriereschicht (C) kann mit dem Bindemittel der Maskenschicht (D) identisch sein, oder es kann sich um ein anderes Bindemittel handeln.

Die digitale Bebilderung der Flexodruckelemente erfolgt in der Regel mit Laserapparaturen, welche eine rotierende Trommel zur Aufnahme des Flexodruckelements umfassen. Handelt es sich um ein plattenförmiges Flexodruckelement, so muss es beim Montieren auf die Lasertrommel gebogen werden. Die bildmäßige Belichtung erfolgt im Regelfalle unter Verwendung von Flachbettbelichtern, so dass das Flexodruckelement nach dem Bebildern wieder gerade gebogen werden muss. Die Barriereschicht (C) darf im Zuge des Montierens auf die Trommel nicht reißen und nach dem Demontieren und Geradebiegen dürfen sich kein Runzeln, Wellen oder sonstige störende Strukturen bilden.

In einer bevorzugten Ausführungsform handelt es sich bei dem wasserlöslichen oder wasserdispergierbaren Bindemittel in der Barriereschicht (C) daher um ein weichelastisches Bindemittel.

Beispiele geeigneter weichelastischer Bindemittel umfassen Polyvinylalkohole, teil- und hochverseifte Polyvinylacetate, insbesondere teil- und hochverseifte Poly(ethylenoxidvinylacetat)-Pfropfcopolymere oder wasserlösliche Poly(ethylenvinylalkohol)-Copolymere. Als "teilverseift" im Sinne dieser Erfindung sollen Vinylacetat-Einheiten umfassende Homo- und Copolymere verstanden werden, bei denen 40 mol % bis 70 mol % der ursprünglich vorhandenen Vinylacetateinheiten zu Vinylalkoholeinheiten hydrolysiert wurden. Als "hochverseift" im Sinne dieser Erfindung sollen Vinylacetat-Einheiten umfassende Homo-und Copolymere verstanden werden, bei denen mehr als 70 mol % der ursprünglich vorhandenen Vinylacetateinheiten zu Vinylalkoholeinheiten hydrolysiert wurden.
Vorteilhafterweise können als Bindemittel biologisch abbaubare Polymere verwendet werden, beispielsweise hochverseifte Polyvinylacetate oder Polyvinylacetatcopolymere.

In einer besonders bevorzugten Ausführungsform der Erfindung handelt es sich bei den Bindemitteln um Polyvinylacetate mit einem Verseifungsgrad von 40 mol.-% bis 90 mol.-%. Derartige Polymere enthalten sowohl Vinylacetateinheiten wie Vinylalkoholeinheiten, welche aus den Vinylacetateinheiten durch Verseifung gebildet werden, und sind mit verschiedenen Verseifungsgraden kommerziell erhältlich. Ist der Verseifungsgrad höher als 90 mol.-%, so sind die Schichten häufig zu spröde. Ist der Verseifungsgrad geringer als 40 mol.-%, ist die Sperrwirkung für Sauerstoff im Regelfalle zu gering oder die für eine ausreichende Sperrwirkung notwendige Schichtdicke ist zu hoch, so dass sich die Auflösung der erfindungsgemäßen Flexodruckelemente verringert.

Neben einem oder mehreren wasserlöslichen Bindemitteln kann die Barriereschicht (C) weitere Komponenten enthalten. Beispiele umfassen Weichmacher, Stabilisatoren, Farbstoffe -soweit sie die Transparenz im UV-Bereich nicht zu stark herabsetzen- oder Füllstoffe. Durch die Verwendung von Weichmachern kann die Elastizität der Barriereschicht (C) gegebenenfalls verbessert werden. Die Menge von Füllstoffen beträgt -sofern vorhanden- in der Regel 5 bis 20 Gew.-% bzgl. der Summe aller Komponenten der Barriereschicht (C).

Die Schichtdicke der Barriereschicht (C) beträgt in der Regel 0,3 µm bis 5 µm. Bei Schichtdicken unterhalb von 0,3 µm ist es schwierig, einen homogenen, gleichmäßigen Auftrag und eine ausreichend gleichmäßige Sperrwirkung zu erreichen. Bei Schichtdicken oberhalb von 5 µm kann die Abbildungsgenauigkeit durch zunehmende Streueffekte des UVA-Lichtes reduziert werden. Bevorzugt beträgt die Schichtdicke 0,5 µm bis 3 um, besonders bevorzugt 1 µm bis 2. µm. Die Schichtdicken können gemessen werden, beispielsweise mittels mikroskopischer Aufnahmen eines Schnittes, oder sie können alternativ aus dem Auftragsgewicht und der Dichte des aufgetragenen Materials berechnet werden.

### Wasserlösliche, laserablatierbare Maskenschicht (D)

Auf die Barriereschicht (C) ist eine wasserlösliche, laserablatierbare Maskenschicht (D) aufgebracht. In die laserablatierbare Maskenschicht (D) wird die zu druckende Information mittels eines geeigneten Lasers eingeschrieben.
Die Maskenschicht (D) umfasst mindestens ein wasserlösliches oder wasserdispergierbares elastisches Bindemittel. Selbstverständlich können auch Gemische mehrerer, verschiedener Bindemittel verwendet werden.

Beispiele geeigneter wasserlöslicher oder wasserdispergierbarer Bindemittel umfassen teil- oder hochverseifte Polyvinylester, z.B. teilverseifte Polyvinylacetate, Polyvinylalkoholderivate, wie z.B. teilverseiftes Vinylacetat/Alkylenoxid-Pfropfmischpolymerisat, Ethylenvinylalkohol-Copolymere, Maleinsäureanhydrid-Copolymere wie z.B. Copolymere aus Maleinsäureanhydrid und Isobuten oder Maleinsäureanhydrid und Vinylmethylether, Copolymere aus Vinylacetat und Crotonsäure, wasserlösliche Polyester, wasserlösliche Polyether, Homo- und Copolymere von Vinylpyrrolidon, Vinylcaprolactam, Vinylimidazol, wasserlösliche Polyacrylamide, wasserlösliche Polyurethane, in Wasser lösliche Polyamide oder Mischungen der genannten Polymere.

Hinsichtlich der mechanischen Eigenschaften der Maskenschicht (D) gelten weitgehend die gleichen Anforderungen wie an die Barriereschicht (C). Einzelheiten wurden bereits oben geschildert. Für die Maskenschicht (D) sind daher auch weichelastische Bindemittel bevorzugt. Beispiele besonders geeigneter Bindemittel umfassen teil- oder hochverseifte Polyvinylacetate und teil- oder hochverseifte Vinylacetat / Alkylenoxid- Pfropfmischpolymerisate, Ethylenvinylalkoholcopolymere oder wasserlösliche Polyamide.

Vorteilhaft können als Bindemittel biologisch abbaubare Polymere verwendet werden, beispielsweise hochverseifte Polyvinylacetate oder Polyvinylacetatcopolymere.

Die laserablatierbare Maskenschicht (D) enthält neben dem Bindemittel UV/VIS absorbierende Materialien, wobei die Schichtdicke und/oder die Menge der lichtabsorbierenden Materialien so bemessen werden, dass die optische Dichte der Schicht für UVA-Strahlung 1 bis 5 beträgt. Der UVA-Strahlungsbereich umfasst Licht der Wellenlänge von 300 nm bis 400 nm. Die optische Dichte ist die logarithmische Maßzahl für die Lichtundurchlässigkeit der Schicht in diesem Wellenlängenbereich. Bei der Messung der optischen Dichte wird daher kein Einzelwert der Lichtundurchlässigkeit bei einer bestimmten Wellenlänge ermittelt, sondern ein Mittelwert der Lichtundurchlässigkeiten in einem definierten Wellenlängenbereich. Üblicherweise erfolgt die Messung der optischen Dichte mittels kommerziell verfügbarer Densitometer (z.B. von x-rite), wobei der Wellenlängenbereich vor der Messung ausgewählt wird. Im Sinne der Erfindung beziehen sich alle zitierten Messwerte der optischen Dichte auf den UVA-Bereich, d.h. den Bereich von 300 bis 400 nm.

Bevorzugte optische Dichten der Maskenschicht (D) liegen im Bereich von 2 bis 5. Die hohe optische Dichte gewährleistet, dass die von der Maske bedeckten Bereiche der reliefbildenden Schicht im Zuge der vollflächigen Belichtung mit UVA-Licht nicht polymerisieren.

Als lichtabsorbierendes Material eignen sich insbesondere feinteiliger Ruß, Graphit oder Ruß-Nanopartikel. Diese absorbieren sehr gut im nahen IR Bereich und gewährleisten so bei der Belichtung mit IR-Lasern, wie beispielweise IR-Laserdioden (830 nm) oder Nd-YAG-Lasern (1064 nm) eine schnelle Bebilderung. Selbstverständlich kann die laserablatierbare Maskenschicht (D) aber auch andere UV- oder IR-Absorber auf Pigmentbasis oder lösliche Farbstoffe enthalten. Als Farbstoffe können beispielsweise Phthalocyanine und substituierte Phthalocyanin-Derivate, Cyanin-, und Merocyaninfarbstoffe oder auch Polymethinfarbstoffe oder Azofarbstoffe verwendet werden.

Die Menge der lichtabsorbierenden Materialien beträgt in der Regel 10 Gew.-% bis 50 Gew.-% bezüglich der Menge aller Komponenten der laserablatierbaren Maskenschicht.

Die laserablatierbare Maskenschicht (D) kann optional darüber hinaus noch Weichmacher, Stabilisatoren oder weitere Hilfsmittel, beispielsweise Emulgatoren, Verlaufshilfsmittel oder UV-Absorber enthalten.

Beim Einsatz von Bindemitteln auf Polyvinylalkoholbasis kann es vorteilhaft sein, die Maskenschicht durch Zusatz geeigneter Weichmacher wie Glykole oder Polyethylenglykole oder andere mehrwertige Alkohole zu stabilisieren. Als Stabilisator gegen Vernetzung gut geeignet ist beispielsweise Xyligen-Kalium oder das entsprechende Aluminiumsalz.

Zur Verbesserung der Handhabbarkeit der Maskenschicht (D) kann diese auch chemisch oder physikalisch teilvernetzt werden. Werden Bindemittel auf Polyvinylalkoholbasis eingesetzt, kann beispielsweise die Fingerfestigkeit durch Umsetzung mit Glyoxal erhöht werden. Auch eine Teilvernetzung der Schicht mittels Elektronenstrahlen kann die Handhabbarkeit der Schicht oder deren Haftungsverhalten wesentlich verbessern.

Die Schichtdicke der laserablatierbaren Maskenschicht (D) beträgt in der Regel bevorzugt 0,3 µm bis 5 µm. Bei Schichtdicken unterhalb von 0,3 µm ist es schwierig, eine ausreichende optische Dichte zu erreichen. Bei Schichtdicken von mehr als 5 µm ist die Laserempfindlichkeit des Elementes zu gering, so dass lange Laserzeiten zur Bebilderung notwendig sind. Die Laserempfindlichkeit der Maskenschicht (gemessen als die Energie, die notwendig ist, um 1 cm² Schicht zu ablatieren) sollte zwischen 0,5 und 4 mJ/cm² liegen. Bevorzugt beträgt die Schichtdicke 1 µm bis 3 µm.

### Deckfolie (E)

Die Flexodruckelemente können als oberste Schicht optional eine abziehbare Deckfolie (E) umfassen, welche unter anderem dem Schutz des Flexodruckelements dient. Die Deckfolie wird vor der Verwendung des Flexodruckelements zur Herstellung von Flexodruckplatten abgezogen. Als abziehbare Deckfolien (E) eignen sich insbesondere FPET-Folien mit mäßiger oder geringer Rauigkeit. Typische Rz-Werte sollten unter 1 µm liegen. Beispielsweise kann eine Mylar® A PET-Folie eingesetzt werden.

Bei plattenförmigen Flexodruckelementen ist die Deckfolie (E) im Regelfalle vorhanden. Bei zylinderförmigen Flexodruckelementen ist die Deckfolie (E) im Regelfalle nicht vorhanden, d.h. die oberste Schicht zylinderförmiger Flexodruckelemente ist die laserablatierbare Maskenschicht (D).

### Herstellung der Flexodruckelemente

Die erfindungsgemäße Herstellung der flächigen Flexodruckelemente erfolgt in prinzipiell bekannter Art und Weise, indem man die Komponenten der fotopolymerisierbaren Schicht in einem Extruder aufschmilzt, mischt und die Schmelze des fotopolymerisierbaren Materials durch eine Breitschlitzdüse in den Spalt eines Kalanders austrägt. Über die eine Kalanderwalze läuft eine, optional mit weiteren Schichten, wie beispielsweise einer Haftschicht beschichtete Trägerfolie und über die andere Kalanderwalze läuft ein vorgefertigtes Deckelement ein. Der Schichtenverbund aus dimensionstabiler Trägerfolie (A), fotopolymerisierbarer Schicht (B) sowie Deckfolie (E) mit den Schichten (C) und (D) wird durch Kalandrieren miteinander verbunden.
Bei dem Deckelement handelt es sich um die Deckfolie (E), welche mit der laserablatierbaren Maskenschicht (D) und der Barriereschicht (C) vorbeschichtet ist. Bei der Herstellung des Deckelementes wird zunächst die laserablatierbare Maskenschicht (D) auf die Deckfolie (E) aufgetragen. Dies kann aus Lösung, aus der Schmelze oder durch Sprühen erfolgen. Anschließend wird die bereits mit der Deckfolie (E) verbundene laserablatierbare Maskenschicht (D) mit der Barriereschicht (C) überschichtet.

Um das Anlösen der ersten, bereits aufgebrachten Maskenschicht (D) beim Überschichten mit der Barriereschicht zu vermeiden, kann es erforderlich sein, die Lösungsmittelzusammensetzung der Gießlösungen zu varüeren, oder die laserablatierbare Maskenschicht (D) vor dem Überschichten durch Vernetzung gegen Beschädigungen beim Überschichten zu stabilisieren. Dies kann beispielsweise erfolgen, indem man Polyvinylalkohol als Bindemittel der laserablatierbaren Maskenschicht (D) verwendet und durch Zusatz von Glyoxal leicht vernetzt.

In einer alternativen Ausführungsform können die Maskenschicht (D) und die Barriereschicht (C) auch separat auf jeweils eine Folie beschichtet werden. Die Maskenschicht (D) wird hierbei auf die spätere Deckfolie (E) aufgetragen, während die Barriereschicht (C) auf eine temporäre Hilfsfolie aufgetragen wird. Nach dem Beschichten werden beide Folien mit den Schichtseiten aufeinander laminiert und die temporäre Hilfsfolie abgezogen.

In einer weiteren Ausführungsform kann die Barriereschicht (C) auf eine temporäre Hilfsfolie aufgetragen werden, in den Kalander des oben beschriebenen Extrusionsverfahrens eingefahren werden und so mit der fotopolymerisierbaren Schicht verbunden werden. Von dem entstandenen Element wird anschließend die temporäre Hilfsfolie abgezogen, die Barriereschicht verbleibt dabei auf der fotopolymerisierbaren Schicht. Anschließend wird eine mit der Maskenschicht (D) beschichtete Deckfolie auflaminiert.

Handelt es sich bei den Flexodruckelementen um zylindrische Flexodruckelemente, dann wird zunächst die fotopolymerisierbare Schicht auf den zylindrischen Träger bevorzugt nahtlos aufgebracht. Entsprechende Verfahren sind dem Fachmann bekannt. Auf die fotopolymerisierbare Schicht werden anschließend die Barriereschicht (C) und die laserablatierbare Maskenschicht (D) aufgebracht. Dies kann beispielsweise in prinzipiell bekannter Art und Weise durch Rollercoating, Ringbeschichtung oder Sprühbeschichtung erfolgen.

### Erfindungsgemäße Verarbeitung der Flexodruckelemente zu Flexodruckformen

Das erfindungsgemäße Verfahren zur Herstellung von Flexodruckplatten unter Verwendung der beschriebenen, digital bebilderbaren Flexodruckelemente umfasst die Verfahrensschritte (1) bis (6). Das Verfahren kann selbstverständlich optional noch weitere Verfahrensschritte umfassen. Sofern eine Deckfolie (E) vorhanden ist, wird die Deckfolie in einem dem Verfahrensschritt (1) vorgelagerten Verfahrensschritt (0) vom Flexodruckelement entfernt.

### Verfahrensschritt (1)

In Verfahrensschritt (1) wird in prinzipiell bekannter Art und Weise eine Maske in die laserablatierbare Maskenschicht (D) mithilfe eines IR-Lasers eingeschrieben. Laserapparaturen zum Einschreiben von Masken sind dem Fachmann bekannt und sind kommerziell erhältlich. Prinzipiell können alle marktüblichen Laser, überwiegend Außentrommellaser, aber auch Flachbettbelichter verwendet werden.

In einer Ausführungsform der Erfindung kann man zur Ausführung von Verfahrensschritt (1) eine Laserapparatur umfassend eine rotierbare Trommel einsetzen. Das plattenförmige oder zylindrische Flexodruckelement wird zum Bebildern - mit dem Träger zur Trommel gerichtet - auf die Trommel montiert bzw. aufgezogen. Handelt es sich um ein plattenförmiges Flexodruckelement, so versteht es sich von selbst, dass das Flexodruckelement hierbei gebogen wird und sich die Schichten hierbei etwas dehnen.

### Verfahrensschritt (2)

In Verfahrensschritt (2) wird das bebilderte Flexodruckelement mit UVA-Strahlung durch die gebildete Maske hindurch in prinzipiell bekannter Art und Weise belichtet. Hierbei polymerisiert die fotopolymerisierbare Schicht in den von der Maske nicht mehr abgedeckten Bereichen, während in den abgedeckten Bereichen keine Polymerisation erfolgt. Die fotopolymerisierbare Schicht wird während der Belichtung durch die Barriereschicht (C) vor dem Einfluss von nachdiffundierendem Sauerstoff geschützt.

Apparaturen zum Belichten von plattenförmigen und zylindrischen Flexodruckelementen sind dem Fachmann prinzipiell bekannt. Die Belichtung der Flexodruckelemente kann beispielsweise mit marktüblichen Röhrenbelichtern erfolgen. UV-LED-Hochenergieleisten müssen nicht eingesetzt werden, können aber jederzeit verwendet werden. Handelt es sich bei den erfindungsgemäßen Flexodruckelementen um zylindrische Flexodruckelemente, muss die flächige UVA-Belichtung naturgemäß in Rundbelichtern erfolgen.

### Verfahrensschritte (3) und (4)

Erfindungsgemäß erfolgt das Auswaschen der belichteten Flexodruckelemente mittels eines zweistufigen Verfahrens umfassend die Verfahrensschritte (3) und (4).

In einem ersten Verfahrensschritt (3) werden die Reste der laserablatierbaren Maskenschicht (D) sowie die Barriereschicht (C) unter Verwendung eines wässrigen Auswaschmittels entfernt. Das wässrige Auswaschmittel umfasst mindestens 80 Gew.-% Wasser, bevorzugt mindestens 90 Gew.-%. Neben Wasser können mit Wasser mischbare Lösemittel, beispielsweise Alkohole wie Methanol, Ethanol, n-Propanol oder i-Propanol verwendet werden. Bevorzugt umfasst das wässrige Auswaschmittel ausschließlich Wasser als Lösemittel. Tenside, die den Lösevorgang unterstützen, können in Anteilen von üblicherweise 0,1 Gew.-% bis 10% dem Wasser zugefügt werden.

In einem zweiten Verfahrensschritt (4) werden die nicht polymerisierten Anteile der reliefbildenden Schicht (B) unter Verwendung eines organischen Auswaschmittels entfernt. Das organische Auswaschmittel umfasst mindestens ein organisches Lösemittel oder ein organisches Lösemittelgemisch. Es können selbstverständlich marktübliche, kommerziell erhältliche organische Flexoauswaschmittel verwendet werden. Beispielsweise können die in EP 332 070 A2 beschriebenen organischen Flexoauswaschmittel verwendet werden.

In einer bevorzugten Ausführungsform der Erfindung umfasst das organische Auswaschmittel als Lösemittel mindestens 80 Gew.-% unpolare Lösemittel, bevorzugt mindestens 90 Gew.-% und besonders bevorzugt umfasst das Auswaschmittel als Lösemittel ausschließlich unpolare Lösemittel. Geeignete unpolare Lösemittel weisen bevorzugt einen Siedepunkt von mindestens 150°C auf. Beispiele geeigneter unpolarer Lösemittel umfassen Kohlenwasserstoffe bzw. Kohlewasserstoffgemische oder Ester. Bei den Kohlenwasserstoffen kann es sich insbesondere um hochsiedende aliphatische, cycloaliphatische oder aromatische Kohlenwasserstofffraktionen, insbesondere solche mit einem Siedebereich von 160 bis 220°C handeln. Besonders bevorzugt sind Kohlenwasserstofflösungsmittel mit einem Siedebereich innerhalb des Bereichs von 160 bis 220°C, die paraffinische und naphthenische Kohlenwasserstoffe umfassen (beispielsweise Exxsol® D 60). Derartige Kohlenwasserstofflösungsmittel sind geruchlos, können einfach durch Destillation regeneriert werden, und ihre Zusammensetzung verändert sich während des Waschbetriebes nicht wesentlich. Aus sicherheitstechnischen Gründen sollte dem Kohlenwasserstofflösungsmittel ein Antistatikum zugesetzt werden. Entsprechende Additive sind dem Fachmann bekannt.

In einer Ausführungsform der Erfindung kann das Auswaschen unter Verwendung handelsüblicher Auswaschgeräte erfolgen. Auswaschgeräte zum Auswaschen plattenförmiger bzw. zylindrischer belichteter Flexodruckelemente sind dem Fachmann prinzipiell bekannt. Handelt es sich bei den erfindungsgemäßen Flexodruckelementen um plattenförmige Flexodruckelemente (Herstellung von Flexodruckplatten), wird das Auswaschen bevorzugt in Flachwaschern durchgeführt. Handelt es sich bei den erfindungsgemäßen Flexodruckelementen um zylindrische Flexodruckelemente (zur Herstellung von Sleeves) erfolgt das Auswaschen in Rundwaschern.

In einem ersten Auswaschgerät wird Verfahrensschritt (3) unter Verwendung der beschriebenen wässrigen Auswaschmittel durchgeführt, und in einem zweiten Gerät wird Verfahrensschritt (4) unter Verwendung der beschriebenen organischen Auswaschmittel durchgeführt.

Hierbei ist es empfehlenswert, das Flexodruckelement nach Durchführung von Verfahrensschritt (3) zwischenzutrocknen, um eventuell noch anhaftende Reste des wässrigen Auswaschmittels zu entfernen und so eine Verunreinigung der organischen Auswaschmittel für Verfahrensschritt (4) zu vermeiden, da ansonsten Probleme mit Schäumen oder der Verschmutzung der Waschanlage auftreten können. Hierbei ist es zu empfehlen sowohl die Oberseite als auch die Unterseite des Flexodruckelements sorgfältig von allen Wasserspuren zu befreien. Das Entfernen von Resten wässriger Auswaschmitteln kann beispielweise unter Verwendung konventioneller Umlufttrockner, IR- oder Mikrowellenstrahler oder durch Aufblasen mit Pressluft aus einzelnen Düsen oder ein durchgängiges Luftrakel erfolgen. Da die reliefbildende Schicht organisch löslich ist, kann sie in Wasser nicht aufquellen.

Bei plattenförmigen Flexodruckelementen können die Verfahrensschritte (3) und (4) vorteilhaft unter Verwendung eines einzigen Auswaschgeräts mit zwei Waschzonen, einem sogenannten Zwei-Zonen-Wascher durchgeführt werden.

Der Zwei-Zonen-Wascher umfasst mindestens eine erste Wascheinheit (W1), eine Zwischentrockeneinheit (Z) und eine zweite Wascheinheit (W2), welche jeweils mit Transportvorrichtungen (T) zum Transport der Flexodruckelemente von einer Einheit zur nächsten miteinander verbunden sind. Die Wascheinheit (W1) dient zur Durchführung von Verfahrensschritt (3), d.h. zum Auswaschen der belichteten Flexodruckelemente mit wässrigen Auswaschmitteln und die Wascheinheit (W2) dient zur Durchführung von Verfahrensschritt (4), d.h. zum Auswaschen der belichteten Flexodruckelemente mit organischen Auswaschmitteln.

Bei den beiden Wascheinheiten (W1) und (W2) handelt es sich jeweils um Flachbettwascher, d.h. Wascheinheiten, in denen das plattenförmige Flexodruckelement in ebenem Zustand verarbeitet wird. Die zu verarbeitenden Flexodruckelemente werden mit der Unterseite, d.h. mit dem dimensionsstabilen Träger nach unten gerichtet in den Zwei-Zonen-Wascher eingelegt. Der Transport der Flexodruckelemente durch den Zwei-Zonen-Wascher kann durch Spindeln oder Ketten erfolgen, welche beiderseits der Wascheinheiten (W1) und (W2) und der Zwischentrockeneinheit (Z) angeordnet sind, und in die die Flexodruckelemente beispielsweise mittels einer Transportleiste eingehängt werden. Ein Kettenantrieb hat den Vorteil, dass der Transport der Flexodruckelemente nicht notwendigerweise horizontal erfolgen muss. Man kann beispielsweise Flexodruckelement in leichtem Gefälle in die Auswaschzonen einführen und am Ende mittels eines leichten Anstiegs herausführen. Auf diese Art und Weise verhindert man das Heraustragen von Auswaschmitteln.

Die Zwischentrockeneinheit (Z) dient dazu zu vermeiden, dass Wasserspuren aus der ersten Wascheinheit (W1) in die zweite Waschzone gelangen, da ansonsten Probleme mit Schäumen oder Verschmutzung der Waschanlage auftreten können. Mögliche Techniken zur Trocknung wurden bereits erwähnt.

Zur mechanischen Unterstützung der Auswaschvorgänge in den Wascheinheiten (W1) und (W2) können die Flachbettwascher in prinzipiell bekannter Art und Weise verschiedene Bürsten oder Plüschwalzen umfassen. Alternativ kann das Auswaschen auch berührungslos durch einfaches Abspülen oder Besprühen mit Wasser erfolgen, wobei einfaches Abspülen für Wascheinheit (W2) in der Regel nicht empfehlenswert ist. Als Bürsten kommen Rundbürsten, Topfbürsten, Kegel- oder Walzenbürsten in Frage. Die Bürsten, Walzen oder Sprühköpfe können über der Plattenbreite oszillieren oder kreisrunde Bewegungen machen. Auch eine Unterstützung des Lösevorgangs durch Anwendung von Ultraschall ist möglich. Am Ende der Waschzonen kann es erforderlich sein, die Oberseite und Unterseite der Flexodruckelemente nochmals mit reinem Auswaschmittel zu säubern.

Das Abwasser der ersten Waschzone (W1) kann optional in einem Tank gesammelt und bis zum Erreichen des maximalen Feststoffanteils im Kreislauf geführt. Der Feststoffanteil sollte 5 Gew.-% nicht übersteigen. Wird das Waschwasser im Kreislauf geführt, ist es zu empfehlen, einen Filter zur Entfernung dispergierter Substanzen einzubauen. Die Temperatur des Wassers kann durch Thermostate geregelt werden. Sie sollte in einem Bereich zwischen 15°C und 40°C geregelt werden.

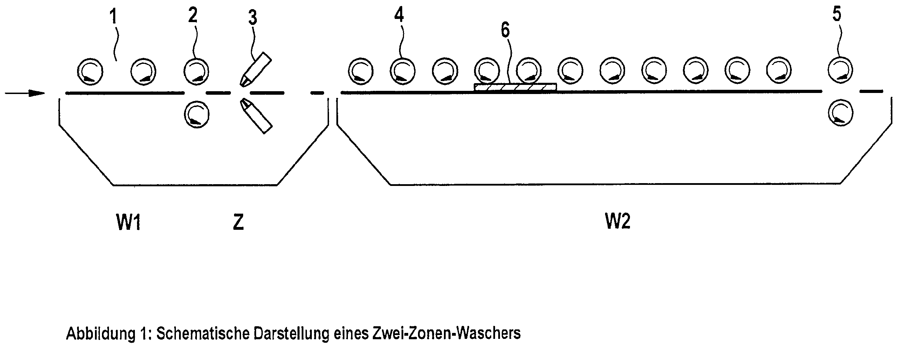

Abbildung 1 zeigt schematisch eine Ausführungsform eines Zwei-Zonen-Waschers umfassend eine erste Waschzone (W1), eine Zwischentrockenzone (Z) und eine zweite Waschzone (W2). Waschzone (W1) umfasst Rundbürsten (1) zum Entfernen der laserablatierbaren Maskenschicht und der Barriereschicht. Die Abtrennung der Waschzone (W1) zur Zwischentrockenzone (Z) kann mittels oberhalb und unterhalb der Platte angeordneter Barriere-Bürsten (2) erfolgen. Das Zwischentrocknen erfolgt mit Luftrakeln (3). Die zweite Waschzone (W2) umfasst Rundbürsten (4) zum Auswaschen der Reliefschicht. Am Ende der zweiten Waschzonen können zusätzliche Waschbürsten (5) zum Nachreinigen mit Frischlösemittel angeordnet sein. Die Flexodruckelemente (6) werden mittels der Transporteinheit (T) (in der Zeichnung nicht dargestellt) durch den Zwei-Zonen-Wascher transportiert.

### Verfahrensschritte (5) und (6)

In Verfahrensschritt (5) wird die erhaltene Flexodruckplatte in prinzipiell bekannter Art und Weise getrocknet und in Verfahrensschritt (6) in prinzipiell bekannter Art und Weise mit UVA- und/oder UVC-Licht nachbehandelt.

Vorteile der erfindungsgemäßen Flexodruckelemente und des erfindungsgemäßen Verfahrens:
Die erfindungsgemäßen Flexodruckelemente erlauben die bildmäßige Übertragung feinster Strukturen. Das Bebildern der Maskenschicht kann mit unterschiedlichen Lasern erfolgen. Gut geeignet sind Diodenlaser, die im Bereich von 830 nm oder 900 nm emittieren oder auch Faserlaser, die bei 1064 nm emittieren. Die Bebilderung der Maskenschicht kann mit einer Auflösung von 2000 dpi bis zu 10000 dpi erfolgen. Dadurch können die Oberflächen der Bildelemente der Flexodruckklischees nahezu beliebig strukturiert werden, um das Druckverhalten je nach geforderter Anwendung zu optimieren. Oberflächenstrukturen zur Steigerung des Farbübertrages oder zur gleichmäßigeren Übertragung des Farbfilmes im Flexodruck sind dem Fachmann bekannt. Gut geeignet sind beispielsweise die von Esko angebotenen Raster: HD Flexo Screen MG 25, MG 2x3 bzw. MC WSI. Hierbei werden die einzelnen Laserspots periodisch an und ausgeschaltet sodass feine Strukturen wie regelmäßige Punkte, Linien oder andere geometrische Strukturen auf der Oberfläche der Flexoklischees erzeugt werden. Die Abmessung dieser Oberflächenstrukturen (< 20 µm) ist geringer als die Größe eines typischen Rasterpunktes, so dass nicht nur flächige Bildelemente sondern auch die Oberfläche einzelner Rasterpunkte mit einer feinen Struktur versehen werden kann.

Alternativ können mit den erfindungsgemäßen Flexodruckelementen auch Oberflächenstrukturen auf analoge Weise erzeugt werden. Enthält die Barriereschicht (C) beispielsweise Füllstoffe im µm oder sub-µm Bereich, entsteht eine raue Oberfläche.

Diese Oberflächenstruktur kann bei der flächigen UVA-Belichtung auf die reliefbildende Schicht übertragen werden. Zur Optimierung der Farbübertragungseigenschaften der erfindungsgemäßen Flexodruckelemente kann es daher erforderlich sein, für bestimmte Druckanwendungen Barriereschichten mit gezielter Rauigkeit herzustellen. Alternativ zum Auswaschen können die erfindungsgemäßen Flexodruckelemente auch thermisch entwickelt werden, wobei dann der Trocknungsschritt entfällt. Das Auswaschen mittels eines zweistufigen Verfahrens erfordert zwar einen Verfahrensschritt mehr als bei einstufigem Auswaschen. Mit dem zweistufigen Prozess sind aber eine Reihe von Vorteilen an anderer Stelle verbunden, welche die Nachteile bei weitem kompensieren. Da die Maskenschicht in einem ersten Schritt separat entfernt wird, kommt es zu keiner Verschmutzung der organischen Auswaschmittel im zweiten Waschschritt. Weiterhin reicht zum Auswaschen der reliefbildenden Schicht im zweiten Auswaschschritt ein Auswaschmittel, welches nur Kohlenwasserstoffe umfasst. Es sind keine mäßig polare Alkohole (welche meist unangenehm riechen) für die organische Auswaschlösung erforderlich. Die Aufarbeitung der organischen Auswaschmittel ist daher sehr viel einfacher als bei mehrkomponentigen, zusätzlich mit Ruß verschmutzten Auswaschmitteln.

Weiterhin können für die Barriereschicht (C) sowie die Maskenschicht (D) biologisch abbaubare, wasserlösliche Polymere verwendet werden, wie beispielsweise teil- oder hochverseifte Polyvinylacetate oder Polyvinylacetat-Copolymere. Daher kann das Abwasser der ersten Waschzone direkt in das Abwasser gegeben werden, ohne dass eine Nachbehandlung erforderlich ist.

Die Erfindung wird in den folgenden Beispielen näher beschrieben.

### Vergleichsbeispiel 1:

| | |
|---|---|
| Fotopolymerisierbare Schicht: | löslich in organischen Auswaschmitteln |
| Barriereschicht für Sauerstoff: | - |
| Laserablatierbare Maskenschicht: | löslich in organischen Auswaschmitteln |

Es wurde ein handelsübliches, digital bebilderbares Flexodruckelement mit einer organisch entwickelbaren fotopolymerisierbaren Schicht sowie einer ebenfalls in organischen Auswaschmitteln entfernbaren, laserablatierbaren Maskenschicht verwendet (Typ nyloflex® ACE 114 D). Das Flexodruckelement weist keine Barriereschicht für Sauerstoff auf. Das Auftragsgewicht der Maskenschicht beträgt 2,6 g/m², die optische Dichte der Maskenschicht im UVA-Bereich, gemessen mit einem Densitometer des Typs Macbeth® TD 904, beträgt 4,1.

Das Flexodruckelement wurde zunächst 10 Sekunden rückseitig vorbelichtet. Die Deckfolie wurde abgezogen. Nach der Vorbelichtung wurde in die Maskenschicht des Flexodruckelements mithilfe eines IR-Lasers ein Testmotiv eingeschrieben. Die Nichtbildbereiche bleiben hierbei aufgrund der noch verbleibenden Maskenschicht UVundurchlässig, während durch die Entfernung der Maske in den Bildbereichen die Härtung der fotopolymerisierbaren Reliefschicht mittels aktinischer Strahlung ermöglicht wird. Die Bebilderung der digitalen Maske wurde mit Hilfe eines Ablationslasersystems "CDI Spark 4835" der Firma Esko vorgenommen, wobei die verwendete Maskenauflösung 4000 dpi betrug und der Laser mit einer hochauflösenden Optikoption (Pixel+) ausgestattet war. Als RIP Software wurde HD Flexo 2.0 von EskoArtwork verwendet. Das Testmotiv enthielt einen Rasterkeil mit Tonwerten von 1% bis 99% bei einer Auflösung von 47 L/cm sowie verschiedene Vollflächenelemente mit und ohne Oberflächenstruktur. Als Oberflächenstrukturen wurden die Raster MG 25 und MC WSI verwendet. Die Bestimmung der Laserenergie wurde über Tonwertmessungen mit einem Peret Flex³ Pro Densitometer der Firma X-Rite vorgenommen, indem bei verschiedenen Laserleistungen das Ablationsergebnis des 40% Tonwerts bei verschiedenen Energien betrachtet wurde. Entsprach der gemessene Tonwert der Vorlage, wurde das gesamte Testmotiv mit dieser Energie bebildert. Das hier beschriebene Flexodruckelement wurde daraufhin auf die Lasertrommel montiert und mit der ermittelten Energie von 3,2 J/cm² bebildert.

Das so vorbereitete Flexodruckelement wurde anschließend für 14 Minuten mit UVA-Strahlung durch die gebildete Maske hindurch belichtet (nyloflex® F III Belichter, Flint Group).

Anschließend wurde das Flexodruckelement mithilfe eines handelsüblichen organischen Auswaschmittels (nylosolv® A) aus ca. 70 Gew.-% Kohlenwasserstoffen und ca. 30 Gew.-% eines Alkohols ausgewaschen (Auswaschgeschwindigkeit 240 mm/min, nyloflex® F III-Auswaschgerät). Hierbei wurden sowohl die Reste der Maskenschicht sowie die nicht fotopolymerisierten Anteile der reliefbildenden Schicht entfernt.

Nach dem Auswaschprozess wurden die noch lösemittelhaltigen Platten gemäß den produktspezifischen Empfehlungen 90 Minuten bei 60 bis 65°C getrocknet und anschließend in der Nachbelichtungseinheit eines nyloflex® F III-Belichters mit UVA- und UVC-Licht nachbelichtet. Die Nachbelichtung dient einerseits dazu, noch reaktive Restmengen an Monomer und Fotoinitiator umzusetzen, andererseits wird die Plattenoberfläche hierdurch klebfreier.

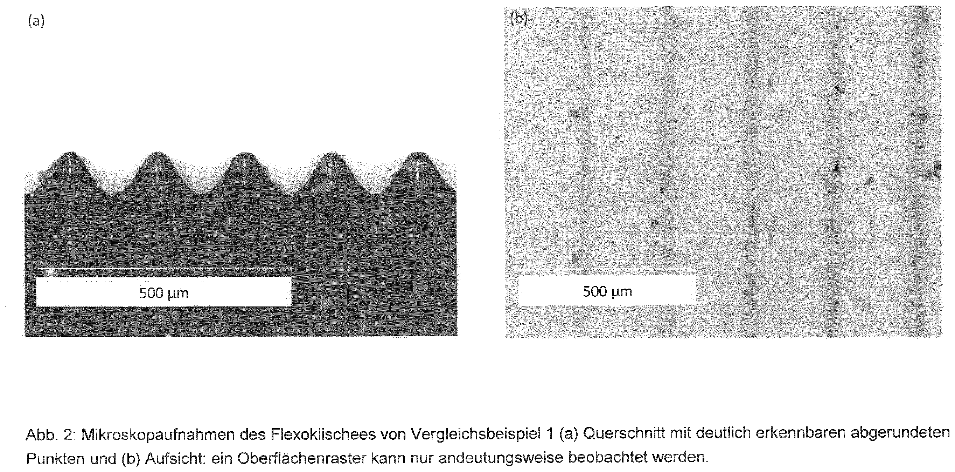

Die Auswertung des Klischees ergab, dass in der Regel hauptsächlich abgerundete Rasterpunkte beobachtet werden können (siehe Abb. 2a). Niedrige Rastertonwerte können gar nicht mehr auf der Platte abgebildet werden. Bei einer Rasterweite von 47 L/cm beträgt der kleinste abgebildete Rastertonwert 4,3 %. Oberflächenraster können nicht aus der Bebilderung auf das Klischee übertragen werden und sind nur andeutungsweise sichtbar (siehe Abb. 2b).

### Vergleichsbeispiel 2

| | |
|---|---|
| Fotopolymerisierbare Schicht: | löslich in organischen Auswaschmitteln |
| Barriereschicht für Sauerstoff: | - |
| Laserablatierbare Maskenschicht: | wasserlöslich |

Die digitale Maskenschicht wurde wie folgt hergestellt:
Zu 100 kg Wasser wurden 23 kg Levanyl® Schwarz A-SF gegeben und kurz gerührt. Anschließend wurden 40,0 kg 20%ige Alcotex® 97-5-Lösung (teilverseiftes Polyethylenoxid-Polyvinylacetat Pfropfcopolymer mit einem Verseifungsgrad von 97 mol %, Lösungsmittelzusammensetzung 80 % Wasser / 20 %Propanol) zugegeben und die Mischung für 5 Minuten gerührt. Im Anschluss wurde zu dieser Mischung 29 kg *n-*Propanol gegeben und erneut für 10 Minuten gerührt. Zuletzt wurden 0,08 kg Capstone® FS-30 als Verlaufshilfsmittel zugegeben und die Mischung für ca. 10 Minuten bei etwa 600 Umdrehungen pro Minute gerührt. Im Anschluss daran wurde die Reaktionslösung über Nacht sehr langsam weiter gerührt. Danach wurde die Lösung mit einem Nassauftrag von 145 µm bei einer Geschwindigkeit von 6,0 m/min auf eine 100 µm dicke Mylar® PET-Folie aufgetragen.

Das Auftragsgewicht der Maskenschicht, welches über gravimetrische Messungen erhalten wurde, beträgt 2,8 g/m², die optische Dichte der Maskenschicht im UVA-Bereich, gemessen mit einem Densitometer des Typs Macbeth® TD 904, beträgt 4,1.

Von einem handelsüblichen, organisch entwickelbaren Flexodruckelement (nyloflex® ACE 114, die fotopolymerisierbare Schicht ist die gleiche wie bei Vergleichsbeispiel 1, nur weist das vorliegende Flexodruckelement keine digital bebilderbare Maskenschicht auf) wurden zunächst die Deckfolie und die dünne Entklebungsschicht abgezogen. Anschließend wurde das beschriebene Folienelement mit der Maskenschicht auf die fotopolymerisierbare Oberfläche mittels eines Laminators aufkaschiert. Die Temperatur der Laminierwalzen wurde auf 110°C eingestellt. Der Verbund aus Basisfolie, fotopolymerisierbarer Schicht, Maskenschicht und Deckfolie wurde noch für 3 h bei 65 °C temperiert.

Das Flexodruckelement wurde zunächst rückseitig 10 Sekunden vorbelichtet. Die Deckfolie wurde abgezogen. Das rückseitig vorbelichtete Flexodruckelement wurde auf die rotierbare Trommel eines IR-Lasers (Laser "CDI Spark 4835", Esko) aufgebracht. Die zur Belichtung notwendige Laserenergie wurde wie in Vergleichsbeispiel 1 ermittelt. Sie wurde zu 2,2 J/cm² bestimmt. Anschließend wurde in die Maskenschicht mithilfe des IR-Lasers das Testmotiv eingeschrieben.

Das bebilderte Flexodruckelement wurde anschließend analog Vergleichsversuch 1 mit UVA-Strahlung 14 Minuten belichtet.

Das Auswaschen erfolgte in zwei Schritten.

Zunächst wurden die Reste der laserablatierbare Maskenschicht in einem ersten Auswaschschritt mit Wasser abgewaschen und noch anhaftendes Wasser durch Abblasen mit Pressluft entfernt.
Anschließend wurde in einem zweiten Auswaschschritt die reliefbildende Schicht unter Verwendung eines organischen Auswaschmittels entwickelt (Auswaschgeschwindigkeit 240 mm/min, nyloflex® F III-Auswaschgerät). Als Auswaschmittel wurde ein technisches Gemisch aromatenfreier Kohlenwasserstoffe mit einem Siedebereich von ca. 180 bis 220°C verwendet (Exxsol® D 60).
Danach wurde die Druckplatte wie unter Vergleichsbeispiel 1 beschrieben nachbearbeitet. Die Auswertung des Klischees ergab, dass in der Regel hauptsächlich abgerundete Rasterpunkte beobachtet werden können. Niedrige Rastertonwerte können gar nicht mehr auf der Platte abgebildet werden. Bei einer Rasterweite von 47 L/cm beträgt der kleinste abgebildete Rastertonwert 4,3%. Oberflächenraster können nicht aus der Bebilderung auf das Klischee übertragen werden und sind wiederum nur andeutungsweise auf der Oberfläche sichtbar.

### Beispiel 1

| | |
|---|---|
| Fotopolymerisierbare Schicht: | löslich in organischen Auswaschmitteln |
| Barriereschicht für Sauerstoff: | wasserlöslich |
| Laserablatierbare Maskenschicht: | wasserlöslich |

Die wasserentwickelbare Maskenschicht wurde wie in Vergleichsbeispiel 2 beschrieben erhalten und wie beschrieben auf eine PET-Folie aufgetragen. Das Auftragsgewicht betrug 2.8 g/m². Die optische Dichte im UVA-Bereich, gemessen mit einem Densitometer des Typs Macbeth® TD 904, betrug 4,1.

Die wasserentwickelbare Barriereschicht wurde wie folgt erhalten:
3 Teile eines teilverseiften Polyvinylacetat-Copolymers (Alcotex® 72.5, Hydrolysegrad ca. 72 mol %) wurden zu 97 Teilen eines Lösungsmittelgemisches aus Wasser und *n-*Propanol im Verhältnis 1:1 unter Rühren gegeben. Anschließend wurde die entstandene Dispersion für 2 h auf 80 °C unter Rückfluss erhitzt. Danach wurde die auf Raumtemperatur abgekühlte Beschichtungslösung mit einer Geschwindigkeit von 33,7 mm/s und einem Nassauftrag von 75 µm auf eine 100 µm dicken PET-Folie gerakelt. Das Auftragsgewicht betrug 1,5 g/m², welches über gravimetrische Messungen erhalten wurde.

Von einem handelsüblichen, organisch entwickelbaren Flexodruckelement (nyloflex® ACE 114) wurden zunächst die Deckfolie und die dünne Entklebungsschicht abgezogen. Dann wurde zunächst das beschriebene Folienelement mit der Barriereschicht auf die fotopolymerisierbare Oberfläche mittels eines Laminators aufkaschiert. Anschließend wurde die PET-Folie abgezogen und die wasserentwickelbare abwaschbare Maskenschicht auf die Barriereschicht aufkaschiert. Der Verbund wurde 3 h bei 65 °C temperiert.

Das erhaltene Flexodruckelement wurde zunächst rückseitig 10 Sekunden vorbelichtet. Die Deckfolie wurde abgezogen. Das rückseitig vorbelichtete Flexodruckelement wurde auf die rotierbare Trommel eines IR-Lasers (Laser "CDI Spark 4835", Esko) aufgebracht. Die zur Belichtung notwendige Laserenergie wurde wie in Vergleichsbeispiel 1 ermittelt. Sie wurde zu 2,2 J/cm² bestimmt. Anschließend wurde in die Maskenschicht mithilfe des IR-Lasers das Testmotiv eingeschrieben.

Das bebilderte Flexodruckelement wurde anschließend analog Vergleichsversuch 1 mit UVA-Strahlung 14 Minuten belichtet.

Das Auswaschen erfolgte in zwei Schritten.

Zunächst wurden die Reste der laserablatierbare Maskenschicht sowie die Sauerstoff-Barriereschicht in einem ersten Auswaschschritt mit Wasser abgewaschen und noch anhaftendes Wasser durch Abblasen mit Pressluft entfernt.
Anschließend wurde in einem zweiten Auswaschschritt die reliefbildende Schicht unter Verwendung eines organischen Auswaschmittels entwickelt (Auswaschgeschwindigkeit 240mm/min, nyloflex® F III-Auswaschgerät). Aus Auswaschmittel wurde wie in Vergleichsbeispiel 2 ein technisches Gemisch aromatenfreier Kohlenwasserstoffe mit einem Siedebereich von ca. 180 bis 220°C verwendet (Exxsol® D 60).

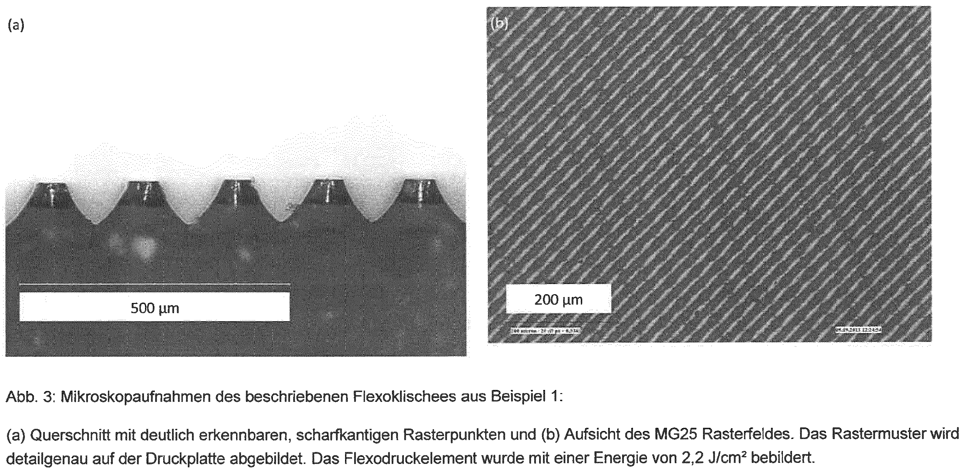

Danach wurde die Druckplatte wie unter Vergleichsbeispiel 1 beschrieben nachbearbeitet. Die Auswertung des Klischees ergab, dass scharfkantige Rasterpunkte auf dem Klischee vorhanden sind (siehe Abb. 3a). Auch niedrige Rastertonwerte können auf der Platte abgebildet werden. Bei einer Rasterweite von 47 L/cm liegt der kleinste stabil abgebildete Rastertonwert bei 0,8%. Oberflächenraster können detailgenau aus der Bebilderung auf das Klischee übertragen werden (siehe Abb. 3b).

### Beispiel 2

| | |
|---|---|
| Fotopolymerisierbare Schicht: | löslich in organischen Auswaschmitteln |
| Barriereschicht für Sauerstoff: | wasserlöslich |
| Laserablatierbare Maskenschicht: | wasserlöslich |

Die wasserentwickelbare Maskenschicht wurde wie folgt hergestellt:
Die in Vergleichsbeispiel 2 beschriebene Beschichtungslösung wurde mit einem Nassauftrag von 125 µm bei einer Geschwindigkeit von 6,8 m/min auf die 100 µm dicke Mylar® PET-Folie aufgetragen. Das Auftragsgewicht betrug 2,0 g/m², welches über gravimetrische Messungen erhalten wurde, die optische Dichte im UVA-Bereich, gemessen mit einem Densitometer des Typs Macbeth® TD 904, betrug 3,5.

Die wasserentwickelbare Barriereschicht wurde wie in Beispiel 1 hergestellt. Das Auftragsgewicht betrug 1,5 g/m², welches über gravimetrische Messungen erhalten wurde.

Von einem handelsüblichen, organisch entwickelbaren Flexodruckelement (nyloflex® ACE 114) wurden zunächst die Deckfolie und die dünne Entklebungsschicht abgezogen.
Dann wurde zunächst das beschriebene Folienelement mit der Barriereschicht auf die fotopolymerisierbare Oberfläche mittels eines Laminators aufkaschiert. Anschließend wurde die PET-Folie abgezogen und die wasserentwickelbare abwaschbare Maskenschicht auf die Barriereschicht aufkaschiert. Der Verbund wurde 3 h bei 65 °C temperiert.
Das Flexodruckelement wurde zunächst rückseitig 10 Sekunden vorbelichtet. Die Deckfolie wurde abgezogen. Das rückseitig vorbelichtete Flexodruckelement wurde auf die rotierbare Trommel eines IR-Lasers (Laser "CDI Spark 4835", Esko) aufgebracht. Die zur Belichtung notwendige Laserenergie wurde wie in Vergleichsbeispiel 1 ermittelt. Sie wurde zu 1,7 J/cm² bestimmt. Anschließend wurde in die Maskenschicht mithilfe des IR-Lasers das Testmotiv eingeschrieben.
Das bebilderte Flexodruckelement wurde anschließend analog Vergleichsversuch 1 mit UVA-Strahlung 14 Minuten belichtet.

Das Auswaschen erfolgte in zwei Schritten.

Zunächst wurden die Reste der laserablatierbare Maskenschicht sowie die Sauerstoff-Barriereschicht in einem ersten Auswaschschritt mit Wasser abgewaschen und noch anhaftendes Wasser durch Abblasen mit Pressluft entfernt.

Anschließend wurde in einem zweiten Auswaschschritt die reliefbildende Schicht unter Verwendung eines organischen Auswaschmittels entwickelt (Auswaschgeschwindigkeit 240 mm/min, nyloflex® F III-Auswaschgerät). Aus Auswaschmittel wurde wie in Vergleichsbeispiel 2 ein technisches Gemisch aromatenfreier Kohlenwasserstoffe mit einem Siedebereich von ca. 180 bis 220°C verwendet (Exxsol® D 60).

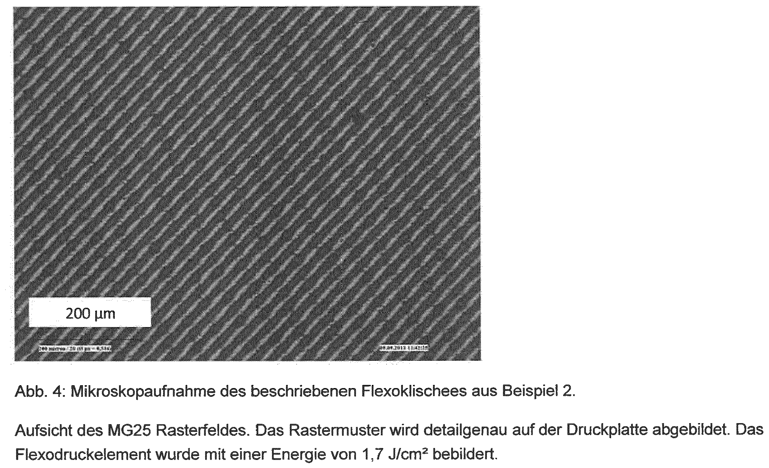

Danach wurde die Druckplatte wie unter Vergleichsbeispiel 1 beschrieben nachbearbeitet. Die Auswertung des Klischees ergab, dass scharfkantige Rasterpunkte auf dem Klischee vorhanden sind. Auch niedrige Rastertonwerte können auf der Platte abgebildet werden. Bei einer Rasterweite von 47 L/cm liegt der kleinste stabil abgebildete Rastertonwert bei 0,8%. Oberflächenraster können detailgenau aus der Bebilderung auf das Klischee übertragen werden (siehe Abb. 4).

### Beispiel 3

| | |
|---|---|
| Fotopolymerisierbare Schicht: | löslich in organischen Auswaschmitteln |
| Barriereschicht für Sauerstoff: | Wasserlöslich, enthält Füllstoffe |
| Laserablatierbare Maskenschicht: | wasserlöslich |

Die wasserentwickelbare Maskenschicht wurde wie in Beispiel 2 hergestellt. Das Auftragsgewicht betrug 2,0 g/m². Die optische Dichte im UVA-Bereich, gemessen mit einem Densitometer des Typs Macbeth® TD 904, betrug 3,5.

Die wasserentwickelbare Barriereschicht wurde analog Beispiel 1 hergestellt. Vor dem Erhitzen der Lösung wurden der Beschichtungslösung zusätzlich noch 0.2 Gewichtsteile (bezogen auf die Menge des eingesetzten Polyvinylalkohols) eines feinteiligen anorganischen Silikats (Syloid® ED30, durchschnittliche Partikelgröße 5,5 µm) als Füllstoff zugesetzt. Es entstand eine milchige Dispersion, die anschließend wie in Beispiel 1 beschrieben auf eine 100 µm dicke PET-Folie aufgerakelt wurde. Das Auftragsgewicht betrug 1,5 g/m².

Von einem handelsüblichen, organisch entwickelbaren Flexodruckelement (nyloflex® ACE 114) wurden zunächst die Deckfolie und die dünne Entklebungsschicht abgezogen. Dann wurde zunächst das beschriebene Folienelement mit der Barriereschicht auf die fotopolymerisierbare Oberfläche mittels eines Laminators aufkaschiert. Anschließend wurde die PET-Folie abgezogen und die wasserentwickelbare abwaschbare Maskenschicht auf die Barriereschicht aufkaschiert. Der Verbund wurde 3 h bei 65 °C temperiert.

Das Flexodruckelement wurde zunächst rückseitig 10 Sekunden vorbelichtet. Die Deckfolie wurde abgezogen. Das rückseitig vorbelichtete Flexodruckelement wurde auf die rotierbare Trommel eines IR-Lasers (Laser "CDI Spark 4835", Esko) aufgebracht. Die zur Belichtung notwendige Laserenergie wurde wie in Vergleichsbeispiel 1 ermittelt. Sie wurde zu 1,7 J/cm² bestimmt. Anschließend wurde in die Maskenschicht mithilfe des IR-Lasers das Testmotiv eingeschrieben.

Das bebilderte Flexodruckelement wurde anschließend analog Vergleichsversuch 1 mit UVA-Strahlung 14 Minuten belichtet.

Das Auswaschen erfolgte in zwei Schritten. Zunächst wurden die Reste der laserablatierbare Maskenschicht sowie die Sauerstoff-Barriereschicht in einem ersten Auswaschschritt mit Wasser abgewaschen und noch anhaftendes Wasser durch Abblasen mit Pressluft entfernt. Anschließend wurde in einem zweiten Auswaschschritt die reliefbildende Schicht unter Verwendung eines organischen Auswaschmittels entwickelt (Auswaschgeschwindigkeit 240 mm/min, nyloflex® F III-Auswaschgerät). Aus Auswaschmittel wurde wie in Vergleichsbeispiel 2 ein technisches Gemisch aromatenfreier Kohlenwasserstoffe mit einem Siedebereich von ca. 180 bis 220°C verwendet (Exxsol® D 60). Danach wurde die Druckplatte wie unter Vergleichsbeispiel 1 beschrieben nachbearbeitet.

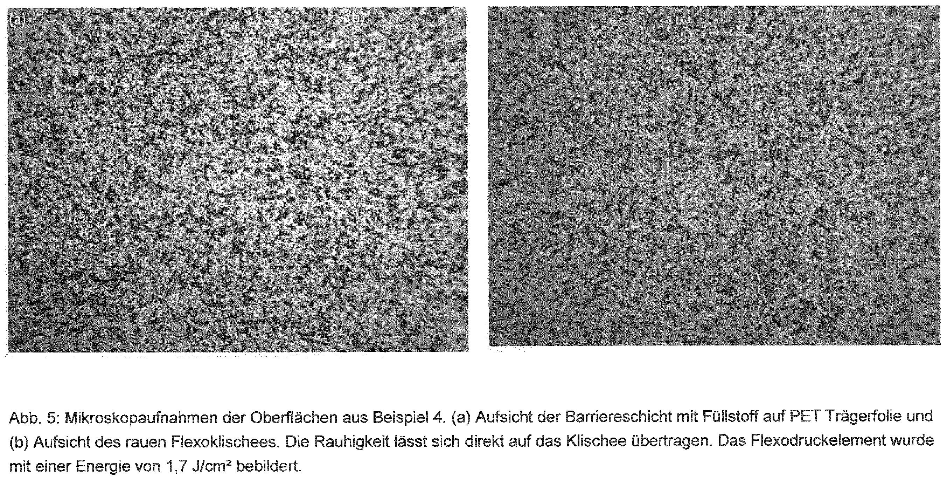

Die Auswertung des Klischees ergab, dass scharfkantige Rasterpunkte auf dem Klischee vorhanden sind. Auch niedrige Rastertonwerte können auf der Platte abgebildet werden. Bei einer Rasterweite von 47 L/cm liegt der kleinste stabil abgebildete Rastertonwert bei 0,8%. Oberflächenraster können detailgenau aus der Bebilderung auf das Klischee übertragen werden. Ferner kann die Geometrie der Oberfläche der Barriereschicht (siehe Abb. 5a) exakt auf die Oberfläche des Klischees (siehe Abb. 5b) übertragen werden.

Die Versuche belegen, dass die erfindungsgemäßen Flexodruckelemente eine hohe Auflösung besitzen, feinste Oberflächenstrukturen abbilden können, mit geringer Energie mittels Laser bebildert werden können und einfach und schnell zum Klischee verarbeitet werden können.

## Patentansprüche

1. Verfahren zur Herstellung von Flexodruckformen, bei dem man als Ausgangsmaterial ein digital bebilderbares, fotopolymerisierbares Flexodruckelement, umfassend - in der genannten Reihenfolge übereinander angeordnet - mindestens
(A) einen dimensionsstabilen Träger,
(B) mindestens eine in organischen Lösemitteln lösliche oder dispergierbare, fotopolymerisierbare, reliefbildende Schicht einer Schichtdicke von 300 µm bis 6000 µm, umfassend mindestens ein elastomeres Bindemittel, ein ethylenisch ungesättigtes Monomer sowie einen Fotoinitiator oder ein Fotoinitiatorsystem,
(C) eine für UVA-Licht transparente Barriereschicht für Sauerstoff mit einer Schichtdicke von 0.3 µm bis 5 µm,
(D) eine laserablatierbare Maskenschicht einer Schichtdicke von 0.3 µm bis 5 µm, umfassend mindestens ein elastomeres Bindemittel und UV/VIS-Licht absorbierende Materialien, wobei die Schichtdicke und/oder die Menge der lichtabsorbierenden Materialien so bemessen werden, dass die optische Dichte der Schicht für UVA-Strahlung 2 bis 5 beträgt, sowie
(E) optional eine abziehbare Deckfolie,
wobei sowohl die Barriereschicht (C) als auch die laserablatierbare Maskenschicht (D) wasserlöslich oder wasserdispergierbar sind, einsetzt, umfassend die folgenden Verfahrensschritte:
(0) Abziehen der Deckfolie (E) sofern vorhanden,
(1) Einschreiben einer Maske in die laserablatierbare Maskenschicht (D) mithilfe eines IR-Lasers,
(2) Belichten des bebilderten Flexodruckelements mit UVA-Strahlung durch die gebildete Maske hindurch,
(3) Entfernen der Reste der laserablatierbaren Maskenschicht (D) und der Barriereschicht (C) unter Verwendung eines wässrigen Auswaschmittels, welches mindestens 90 Gew. Wasser umfasst,
(4) Entfernen der nicht polymerisierten Anteile der reliefbildenden Schicht (B) unter Verwendung eines organischen Auswaschmittels,
(5) Trocknen der erhaltenen Flexodruckform, sowie
(6) Nachbehandeln mit UVA- und/oder UVC-Licht.

2. Verfahren gemäß Anspruch 1, dass die Barriereschicht (C) mindestens ein wasserlösliches oder wasserdispergierbares Bindemittel umfasst.

3. Verfahren Anspruch 2, **dadurch gekennzeichnet, dass** es sich bei dem wasserlöslichen oder wasserdispergierbaren Bindemittel in der Barriereschicht (C) um mindestens ein Bindemittel ausgewählt aus der Gruppe von Polyvinylalkohol, teil- und hochverseiften Polyvinylacetaten, teil- und hochverseiften Poly (ethylenoxidvinylacetat) Pfropfcopolymeren oder wasserlöslichen Poly(ethylenvinylalkohol) Copolymere handelt.

4. Verfahren gemäß Anspruch 2, **dadurch gekennzeichnet, dass** es sich bei dem wasserlöslichen oder wasserdispergierbaren Bindemittel in der Barriereschicht (C) um mindesten ein Polyvinylacetat mit einem Verseifungsgrad von 40 mol % bis 90 mol % handelt.

5. Verfahren gemäß einem der Ansprüche 1 bis 4, **dadurch gekennzeichnet, dass** die Barriereschicht (C) Füllstoffe in einer Menge von 5 bis 20 Gew. % bzgl. der Summe aller Komponenten der Barriereschicht (C) umfasst.

6. Verfahren gemäß einem der Ansprüche 1 bis 5, **dadurch gekennzeichnet, dass** es sich bei dem elastischen Bindemittel in der laserablatierbaren Maskenschicht (D) um mindestens eines ausgewählt aus der Gruppe von teil- oder hochverseiften Polyvinylestern, teilverseiften Vinylacetat/Alkylenoxid-Pfropfmischpolymerisaten, Ethylenvinylalkohol-Copolymeren, Maleinsäureanhydrid-Copolymeren, Copolymeren aus Vinylacetat und Crotonsäure, wasserlöslichen Polyestern, wasserlöslichen Polyethern, Homo- und Copolymeren von Vinylpyrrolidon, Vinylcaprolactam, Vinylimidazol, wasserlöslichen Polyacrylamiden, wasserlöslichen Polyurethanne oder in Wasser löslichen Polyamiden handelt.

7. Verfahren gemäß einem der Ansprüche 1 bis 5, **dadurch gekennzeichnet, dass** es sich bei dem elastischen Bindemittel in der laserablatierbaren Maskenschicht (D) um mindestens eines ausgewählt aus der Gruppe von teil- oder hochverseiften Polyvinylacetaten, teil- oder hochverseiften Vinylacetat-Alkylenoxid-Pfropfmischpolymerisaten, Ethylenvinylalkohol-Copolymeren oder wasserlöslichen Polyamiden handelt.

8. Verfahren gemäß einem der Ansprüche 1 bis 7, **dadurch gekennzeichnet, dass** es sich bei dem lichtabsorbierenden Material in der laserablatierbaren Maskenschicht (D) um mindestens eines ausgewählt aus der Gruppe von feinteiligem Ruß, Graphit oder um Ruß-Nanopartikel handelt.

9. Verfahren gemäß einem der Ansprüche 1 bis 8, **dadurch gekennzeichnet, dass** die Menge der lichtabsorbierenden Materialien in der laserablatierbaren Maskenschicht (D) 10 Gew. % bis 50 Gew. % bezüglich der Menge aller Komponenten der laserablatierbaren Maskenschicht beträgt.

10. Verfahren gemäß einem der Ansprüche 1 bis 9, **dadurch gekennzeichnet, dass** es sich um ein flächenförmiges Flexodruckelement handelt.

11. Verfahren gemäß einem der Ansprüche 1 bis 9, **dadurch gekennzeichnet, dass** es sich um ein zylinderförmiges Flexodruckelement handelt, mit der Maßgabe, dass keine Deckfolie (E) vorhanden ist.

12. Verfahren gemäß einem der Ansprüche 1 bis 11, **dadurch gekennzeichnet, dass** es sich bei dem wässrigen Auswaschmittel in Verfahrensschritt (3) um Wasser handelt.

13. Verfahren gemäß einem der Ansprüche 1 bis 12, **dadurch gekennzeichnet, dass** es sich bei den Bindemitteln in der Barriereschicht (C) und der laserablatierbaren Maskenschicht (D) um biologisch abbaubare Bindemittel handelt, und man verbrauchtes wässriges Auswaschmittel ins Abwasser leitet.

14. Verfahren gemäß einem der Ansprüche 1 bis 13, **dadurch gekennzeichnet, dass** man zwischen den Verfahrensschritten (3) und (4) am Flexodruckelement noch anhaftende Reste des wässrigen Auswaschmittels entfernt.

15. Verfahren gemäß einem der Ansprüche 1 bis 14, **dadurch gekennzeichnet, dass** es sich bei dem in Verfahrensschritt (4) verwendeten organischen Auswaschmittel um ein unpolares Lösemittel mit einem Siedepunkt von mindestens 150°C handelt.

16. Verfahren gemäß einem der Ansprüche 1 bis 14, **dadurch gekennzeichnet, dass** es sich bei dem in Verfahrensschritt (4) verwendeten organischen Auswaschmittel um ein paraffinische und naphthenische Kohlenwasserstoffe umfassendes Kohlenwasserstofflösungsmittel mit einem Siedebereich von 160 bis 220°C handelt.

17. Verfahren gemäß Anspruch 16, **dadurch gekennzeichnet, dass** das Auswaschmittel nur Kohlenwasserstoffe umfasst.

18. Verfahren gemäß einem der Ansprüche 1 bis 10 und 12 bis 17, **dadurch gekennzeichnet, dass** ein flächenförmiges Flexodruckelement verarbeitet wird und zur Durchführung der Verfahrensschritte (3) und (4) ein Zwei-Zonen-Wascher zum Auswaschen von belichteten, digital bebilderten flächenförmigen Flexodruckelementen umfassend mindestens
• eine erste Auswascheinheit (W1), welche unter Verwendung von wässrigen Auswaschmitteln arbeitet,
• eine Zwischentrockeneinheit (Z) zum Entfernen von Resten wässriger Auswaschmittel vom Flexodruckelement,
• eine zweite Auswascheinheit (W2), welche unter Verwendung von organischen Auswaschmitteln arbeitet, sowie
• eine Transportvorrichtung (T) zum Transport der belichteten Flexodruckelemente durch die Einheiten (W1), (Z) und (W2).
eingesetzt wird.

## Claims

1. A method for producing flexographic printing plates, by using as starting material a digitally imagable, photopolymerizable flexographic printing element, comprising at least - arranged one above another in the order stated -
(A) a dimensionally stable support,
(B) at least one photopolymerizable relief-forming layer which is dispersible or soluble in organic solvents and has a layer thickness of 300 µm to 6000 µm, comprising at least one elastomeric binder, an ethylenically unsaturated monomer, and a photoinitiator or photoinitiator system,
(C) a barrier layer for oxygen, which is transparent for UVA light, and which has a layer thickness of 0.3 µm to 5 µm,
(D) a laser-ablatable mask layer with a layer thickness of 0.3 µm to 5 µm, comprising at least one elastomeric binder and materials that absorb UV/VIS light, the layer thickness and/or the amount of the light-absorbing materials being made such that the optical density of the layer for UVA radiation is 2 to 5, and
(E) optionally a removable top film,
where both the barrier layer (C) and the laser-ablatable mask layer (D) are water-soluble or water-dispersible, comprising the following method steps:
(0) removing the top film (E) if present,
(1) writing a mask into the laser-ablatable mask layer (D) by means of an IR laser,
(2) exposing the imaged flexographic printing element with UVA radiation through the mask formed,
(3) removing the residues of the laser-ablatable mask layer (D) and the barrier layer (C) using an aqueous washout medium which comprises at least 90 wt of water,
(4) removing the unpolymerized fractions of the relief-forming layer (B) using an organic washout medium,
(5) drying the resulting flexographic printing plate, and
(6) carrying out aftertreatment with UVA and/or UVC light.

2. The method as claimed in claim 1, that the barrier layer (C) comprises at least one water-soluble or water-dispersible binder.

3. The method claim 2, **characterized in that** the water-soluble or water-dispersible binder in the barrier layer (C) comprises at least one binder selected from the group of polyvinyl alcohol, partly and highly hydrolyzed polyvinyl acetates, partly and highly hydrolyzed poly(ethylene oxide-vinyl acetate) graft copolymers, or water-soluble poly(ethylene-vinyl alcohol) copolymers.

4. The method as claimed in claim 2, **characterized in that** the water-soluble or water-dispersible binder in the barrier layer (C) comprises at least one polyvinyl acetate having a degree of hydrolysis of 40 mol% to 90 mol%.

5. The method as claimed in any of claims 1 to 4, **characterized in that** the barrier layer (C) comprises fillers in an amount of 5 to 20 wt% relative to the sum of all the components of the barrier layer (C).

6. The method as claimed in any of claims 1 to 5, **characterized in that** the elastic binder in the laser-ablatable mask layer (D) comprises at least one selected from the group of partly or highly hydrolyzed polyvinyl esters, partly hydrolyzed vinyl acetate/alkylene oxide graft copolymers, ethylene-vinyl alcohol copolymers, maleic anhydride copolymers, copolymers of vinyl acetate and crotonic acid, water-soluble polyesters, water-soluble polyethers, homo- and copolymers of vinylpyrrolidone, vinylcaprolactam, vinylimidazole, water-soluble polyacrylamides, water-soluble polyurethanes, or water-soluble polyamides.

7. The method as claimed in any of claims 1 to 5, **characterized in that** the elastic binder in the laser-ablatable mask layer (D) comprises at least one selected from the group of partly or highly hydrolyzed polyvinyl acetates, partly or highly hydrolyzed vinyl acetate-alkylene oxide graft copolymers, ethylene-vinyl alcohol copolymers, or water-soluble polyamides.

8. The method as claimed in any of claims 1 to 7, **characterized in that** the light-absorbing material in the laser-ablatable mask layer (D) comprises at least one selected from the group of finely divided carbon black, graphite, or carbon black nanoparticles.

9. The method as claimed in any of claims 1 to 8, **characterized in that** the amount of the light-absorbing materials in the laser-ablatable mask layer (D) is 10 wt% to 50 wt% relative to the amount of all the components of the laser-ablatable mask layer.

10. The method as claimed in any of claims 1 to 9, **characterized in that** it is a flat flexographic printing element.

11. The method as claimed in any of claims 1 to 9, **characterized in that** it is a cylindrical flexographic printing element with the proviso that there is no top film (E) present.

12. The method as claimed in any of claims 1 to 11, **characterized in that** the aqueous washout medium in method step (3) comprises water.

13. The method as claimed in any of claims 1 to 12, **characterized in that** the binders in the barrier layer (C) and the laser-ablatable mask layer (D) comprise biodegradable binders, and spent aqueous washout medium is passed into the wastewater.

14. The method as claimed in any of claims 1 to 13, **characterized in that** residues of the aqueous washout medium still adhering to the flexographic printing element are removed between method steps (3) and (4).

15. The method as claimed in any of claims 1 to 14, **characterized in that** the organic washout medium used in method step (4) comprises an apolar solvent having a boiling point of at least 150°C.

16. The method as claimed in any of claims 1 to 14, **characterized in that** the organic washout medium used in method step (4) comprises a hydrocarbon solvent which comprises paraffinic and naphthenic hydrocarbons and has a boiling range of 160 to 220°C.

17. The method as claimed in claim 16, **characterized in that** the washout medium comprises only hydrocarbons.

18. The method as claimed in any of claims 1 to 10 and 12 to 17, **characterized in that** a flat flexographic printing element is processed and method steps (3) and (4) are carried out using a two-zone washer to wash out exposed, digitally imaged flat flexographic printing elements, comprising at least
• a first washout unit (W1) which operates using aqueous washout media,
• an interim drying unit (Z) for removing residues of aqueous washout media from the flexographic printing element,
• a second washout unit (W2) which operates using organic washout media, and
• a transport device (T) for transporting the exposed flexographic printing elements through the units (W1), (Z), and (W2).

## Revendications

1. Procédé de fabrication de clichés flexographiques, dans lequel on utilise comme matière première un élément flexographique apte à porter une image numériquement et photopolymérisable, comprenant - disposés l'un au-dessus de l'autre dans l'ordre indiqué - au moins
(A) un support de dimensions stables,
(B) au moins une couche formant un relief, soluble ou dispersable dans des solvants organiques, photopolymérisable, avec une épaisseur de couche de 300 µm à 6000 µm, comprenant au moins un liant élastomère, un monomère éthyléniquement non saturé ainsi qu'un photo-initiateur ou un système de photo-initiateur,
(C) une couche de barrière pour l'oxygène transparente à la lumière UV avec une épaisseur de couche de 0,3 µm à 5 µm,
(D) une couche de masque pouvant être ablatée au laser avec une épaisseur de couche de 0,3 µm à 5 µm, comprenant au moins un liant élastomère et des matériaux absorbant la lumière UV/VIS, dans lequel l'épaisseur de couche et/ou la quantité des matériaux absorbant la lumière sont dimensionnées de telle manière que la densité optique de la couche pour un rayonnement UVA vaille 3 à 5, ainsi que
(E) en option une feuille de protection amovible,
dans lequel aussi bien la couche de barrière (C) que la couche de masque pouvant être ablatée au laser (D) sont solubles dans l'eau ou dispersables dans l'eau, comprenant les étapes de procédé suivantes:
(0) retirer la feuille de protection (E) si elle est présente,
(1) inscrire un masque dans la couche de masque pouvant être ablatée au laser (D) à l'aide d'un laser IR,
(2) éclairer l'élément flexographique portant une image avec un rayonnement UVA à travers la couche de masque,
(3) enlever les résidus de la couche de masque pouvant être ablatée au laser (D) et de la couche de barrière (C) en utilisant un agent de lavage aqueux, qui comprend au moins 90 % en poids d'eau,
(4) enlever les fractions non polymérisées de la couche formant un relief (B) en utilisant un agent de lavage organique,
(5) sécher le cliché flexographique obtenu, et
(6) retraiter avec une lumière UVA et/ou UVC.

2. Procédé selon la revendication 1, **caractérisé en ce que** la couche de barrière (C) comprend au moins un liant soluble dans l'eau ou dispersable dans l'eau.

3. Procédé selon la revendication 2, **caractérisé en ce que** le liant soluble dans l'eau ou dispersable dans l'eau dans la couche de barrière (C) est au moins un liant choisi dans le groupe comprenant l'alcool polyvinylique, des acétates de polyvinyle partiellement ou fortement saponifiés, des copolymères greffés de poly(acétate de vinyle oxyde d'éthylène) partiellement ou fortement saponifiés ou des copolymères de poly(éthylène alcool vinylique) solubles dans l'eau.

4. Procédé selon la revendication 2, **caractérisé en ce que** le liant soluble dans l'eau ou dispersable dans l'eau dans la couche de barrière (C) est au moins un acétate de polyvinyle avec un degré de saponification de 40 % molaires à 90 % molaires.

5. Procédé selon l'une quelconque des revendications 1 à 4, **caractérisé en ce que** la couche de barrière (C) comprend des matières de charge en une quantité de 5 à 20 % en poids rapportés à la somme de tous les composants de la couche de barrière (C).

6. Procédé selon l'une quelconque des revendications 1 à 5, **caractérisé en ce que** le liant élastique dans la couche de masque pouvant être ablatée au laser (D) est au moins un liant choisi dans le groupe comprenant des esters de polyvinyle partiellement ou fortement saponifiés, des polymérisats mixtes greffés d'acétate de vinyle/oxyde d'alkylène partiellement saponifiés, des copolymères d'éthylène alcool vinylique, des copolymères d'anhydrides de l'acide maléique, des copolymères d'acétate de vinyle et acide crotonique, des polyesters solubles dans l'eau, des polyéthers solubles dans l'eau, des homo- et copolymères de vinylpyrrolidone, de vinylcaprolactame, de vinylimidazole, des polyacrylamides solubles dans l'eau, des polyuréthanes solubles dans l'eau, ou des polyamides solubles dans l'eau.

7. Procédé selon l'une quelconque des revendications 1 à 5, **caractérisé en ce que** le liant élastique dans la couche de masque pouvant être ablatée au laser (D) est au moins un liant choisi dans le groupe comprenant des acétates de polyvinyle partiellement ou fortement saponifiés, des polymérisats mixtes greffés d'acétate de vinyle-oxyde d'alkylène partiellement ou fortement saponifiés, des copolymères d'éthylène alcool vinylique ou des polyamides solubles dans l'eau.

8. Procédé selon l'une quelconque des revendications 1 à 7, **caractérisé en ce que** le matériau absorbant la lumière dans la couche de masque pouvant être ablatée au laser (D) est au moins un matériau choisi dans le groupe comprenant la suie finement divisée, le graphite finement divisé ou des nanoparticules de suie.

9. Procédé selon l'une quelconque des revendications 1 à 8, **caractérisé en ce que** la quantité des matériaux absorbant la lumière dans la couche de masque pouvant être ablatée au laser (D) vaut 10 % en poids à 50 % en poids rapportés à la quantité de tous les composants de la couche de masque pouvant être ablatée au laser (D).

10. Procédé selon l'une quelconque des revendications 1 à 9, **caractérisé en ce qu'**il concerne un élément flexographique planiforme.

11. Procédé selon l'une quelconque des revendications 1 à 9, **caractérisé en ce qu'**il concerne un élément flexographique cylindrique, avec la condition qu'il n'y a pas de feuille de protection (E).

12. Procédé selon l'une quelconque des revendications 1 à 11, **caractérisé en ce que** l'agent de lavage aqueux dans l'étape de procédé (3) est l'eau.

13. Procédé selon l'une quelconque des revendications 1 à 12, **caractérisé en ce que** les liants dans la couche de barrière (C) et dans la couche de masque pouvant être ablatée au laser (D) sont des liants biologiquement dégradables, et on conduit les agents de lavage aqueux consommés dans les eaux usées.

14. Procédé selon l'une quelconque des revendications 1 à 13, **caractérisé en ce que** l'on élimine entre les étapes de procédé (3) et (4) les résidus de l'agent de lavage aqueux adhérant encore à l'élément flexographique.

15. Procédé selon l'une quelconque des revendications 1 à 14, **caractérisé en ce que** l'agent de lavage organique utilisé dans l'étape de procédé (4) est un solvant non polaire avec un point d'ébullition d'au moins 150°C.

16. Procédé selon l'une quelconque des revendications 1 à 14, **caractérisé en ce que** l'agent de lavage organique utilisé dans l'étape de procédé (4) est un solvant hydrocarboné contenant des hydrocarbures paraffiniques et naphténiques avec un point d'ébullition de 160 à 220°C.

17. Procédé selon la revendication 16, **caractérisé en ce que** l'agent de lavage ne contient que des hydrocarbures.

18. Procédé selon l'une quelconque des revendications 1 à 10 et 12 à 17, **caractérisé en ce que** l'on traite un élément flexographique planiforme et on utilise pour l'exécution des étapes de procédé (3) et (4) un laveur à deux zones pour le lavage d'éléments flexographiques planiformes éclairés, portant une image numérisée, comprenant au moins
• une première unité de lavage (W1), qui travaille en utilisant des agents de lavage aqueux,
• une unité de séchage intermédiaire (Z) pour éliminer des résidus d'agents de lavage aqueux de l'élément flexographique,
• une seconde unité de lavage (W2), qui travaille en utilisant des agents de lavage organiques, ainsi que
• un dispositif de transport (T) pour le transport des éléments flexographiques éclairés à travers les unités (W1), (Z) et (W2).
